# EUROPEAN PATENT APPLICATION

(11) **EP 4 621 781 A2**
(43) Date of publication of application: **24.09.2025**
(21) Application number: 25158776.2
(22) Date of filing: 19.02.2025
(51) Int. Cl.: G11C 11/16, G11C 11/18, H10B 61/00, H10N 50/01, H10N 50/10, H10N 50/80

(54) **MAGNETIC MEMORY DEVICE**

(30) Priority: 22.03.2024 JP 2024045968
(71) Applicant: Kioxia Corporation, Tokyo 108-0023 (JP)
(72) Inventor: YOSHIKAWA, Masatoshi, Minato-ku, Tokyo, 108-0023 (JP); DAIBOU, Tadaomi, Minato-ku, Tokyo, 108-0023 (JP); TAKAHASHI, Kensuke, Minato-ku, Tokyo, 108-0023 (JP)
(74) Representative: Hoffmann Eitle

(57) **Abstract**

A first interconnect and the first insulator extend in a first direction. A second insulator extends in the second direction and penetrates the first interconnect and the first insulator. A second interconnect is provided around the second insulator, extends in the second direction, and penetrates the first interconnect and the first insulator. A first magneto-resistive effect element is provided in a ring-shape around the second interconnect between the first interconnect and the second interconnect, and includes a first ferromagnetic material between the second interconnect and the first interconnect, a first nonmagnetic material between the first ferromagnetic material and the first interconnect, and a second ferromagnetic material between the first nonmagnetic material and the first interconnect.

## Description

### CROSS-REFERENCE TO RELATED APPLICATIONS

This application is based upon and claims the benefit of priority from Japanese Patent Application No. 2024-045968, filed March 22, 2024.

### FIELD

Embodiments described herein relate generally to a magnetic memory device.

### BACKGROUND

Magnetic memory devices in which magneto-resistive effect elements are used as memory elements are known. Various methods have been proposed for writing data to the magneto-resistive effect elements. For example, a writing method using spin-orbit torque is known.

### BRIEF DESCRIPTION OF THE DRAWINGS

FIG. 1 shows a block diagram of an example of the configuration of a magnetic memory device 1 according to the first embodiment.
FIG. 2 shows a circuit diagram of an example of the circuit configuration of a memory cell array 10 according to the first embodiment.
FIG. 3 shows an example of a layout of a plane of the memory cell array 10 of the magnetic memory device 1 according to the first embodiment.
FIG. 4 shows a cross-sectional view taken along line IV-IV in FIG. 3, and is an example of the cross-sectional structure of the magnetic memory device 1 according to the first embodiment.
FIG. 5 shows a cross-sectional view taken along line V-V in FIG. 3, and is an example of a cross-sectional structure of the magnetic memory device 1 according to the first embodiment.
FIG. 6 shows an enlarged view of an area VI in FIG. 4, and is an example of a cross-sectional structure of a memory pillar MP in the magnetic memory device 1 according to the first embodiment.
FIG. 7 shows an example of curves representing voltage and current characteristics of a memory cell of the magnetic memory device 1 according to the first embodiment.
FIG. 8 shows a cross-sectional view taken along line VIII-VIII in FIG. 3, and is an example of a cross-sectional structure of the memory pillar MP provided in the magnetic memory device 1 according to the first embodiment.
FIG. 9 shows an example of voltages that are applied to the memory cell array in a first example of a write operation performed in the magnetic memory device 1 according to the first embodiment.
FIG. 10 shows an example of the current and magnetization direction applied to the memory cell array in the first example of the write operation performed in the magnetic memory device 1 according to the first embodiment.
FIG. 11 shows an example of a current and magnetization direction applied to the memory cell array in a second example of the write operation performed in the magnetic memory device 1 according to the first embodiment.
FIG. 12 and FIG. 13 illustrate an example of a voltage applied to the memory cell array in a read operation performed in the magnetic memory device 1 according to the first embodiment.
FIG. 14 shows a flowchart of an example of a method for manufacturing the magnetic memory device 1 according to the first embodiment.
FIG. 15 to FIG. 27 each show an example of a cross-sectional structure during manufacturing of the magnetic memory device 1 according to the first embodiment.
FIG. 28 shows an example of the cross-sectional structure of a memory pillar MPb in a magnetic memory device 1b according to a modification of the first embodiment.
FIG. 29 shows a cross-sectional view taken along line XXVIIII-XXVIIII in FIG. 28, and is an example of the cross-sectional structure of the memory pillar MPb provided in the magnetic memory device 1b according to the modification of the first embodiment.
FIG. 30 shows an example of a cross-sectional structure of a memory pillar MPc provided in a magnetic memory device 1c according to the second embodiment.
FIG. 31 shows a flowchart of an example of a method for manufacturing the magnetic memory device 1c according to the second embodiment.
FIG. 32 and FIG. 33 each show an example of a cross-sectional structure during manufacturing of the magnetic memory device 1c according to the second embodiment.

### DETAILED DESCRIPTION

In general, according to one embodiment, a magnetic memory device comprising includes a substrate, a first interconnect, a first insulator, a second insulator, a second interconnect, a first magneto-resistive effect element. The first interconnect and the first insulator extend in a first direction along the substrate. The second insulator extends in the second direction and penetrates the first interconnect and the first insulator. The second interconnect is provided around the second insulator, extends in the second direction, and penetrates the first interconnect and the first insulator. The first magneto-resistive effect element is provided in a ring-shape around the second interconnect between the first interconnect and the second interconnect. The first magneto-resistive effect element includes a first ferromagnetic material between the second interconnect and the first interconnect, a first nonmagnetic material between the first ferromagnetic material and the first interconnect, and a second ferromagnetic material between the first nonmagnetic material and the first interconnect.

A description will now be given of embodiments with reference to the accompanying drawings. In the descriptions below, components having similar functions and configurations will be denoted by the same reference symbols. To distinguish a plurality of components having common reference numerals, suffixes will be attached to the common reference numerals. If the components do not need to be distinguished specifically, only the common reference numerals will be used, and no suffixes will be attached. The suffixes are not limited to subscripts and superscripts, but include, for example, lower-case English letters added at the end of reference numerals, and indexes or the like indicating arrangements.

The figures are schematic, and the relation between the thickness and the area of a plane of a layer and the ratio of thicknesses of layers may differ from those in actuality. The figures may include components which differ in relations and/or ratios of dimensions in different figures.

The embodiments will be described using an X-Y-Z orthogonal coordinate system. A plus direction of a vertical axis in a drawing may be referred to as an upper side, and a minus direction of the vertical axis may be referred to as a lower side. A plus direction of a horizontal axis in a drawing may be referred to as a right side, and a minus direction of the horizontal axis may be referred to as a left side. That is, in a plan view showing an X-Y plane (referred to as an X-Y plane view, the same applying hereinafter), an upper side of the X-Y plane represents a +Y direction, a lower side of the X-Y plane represents a -Y direction, a right side of the X-Y plane represents a +X direction, and a left side of the X-Y plane represents a -X direction.

In the plan views, hatching is added where appropriate to make the views easy to see. The hatching added to the plan views is not necessarily related to the materials or characteristics of the hatched components. In the cross-sectional views, components such as insulating layers, substrates, interconnects, terminals, etc. are omitted as appropriate to make the views easy to see.

Steps in the flow of a method according to an embodiment are not limited to any of the shown orders, and may occur in an order different from the shown orders and/or may occur concurrently with another step or steps.

In the present specification and claims, if a first component is "coupled" to a second component, it means that the components are electrically coupled, and does not exclude the case where another components is interposed in between. In addition, "electrically coupling" may be used to describe that an insulating layer is interposed as long as the insulating layer does not affect the proper operation accomplished by the electrical coupling.

In the present specification, a magnetic memory device is, for example, an magnetoresistive random access memory (MRAM). The magnetic memory device includes a magneto-resistive effect element as a memory element. The magneto-resistive effect element is a resistance change element that has a tunnel magneto-resistive effect due to a magnetic tunnel junction (MTJ). This magneto-resistive effect element will be referred to as an MTJ element as well.

### 1. First Embodiment

A magnetic memory device according to the first embodiment will be described. First, the configuration of the magnetic memory device according to the first embodiment will be described.

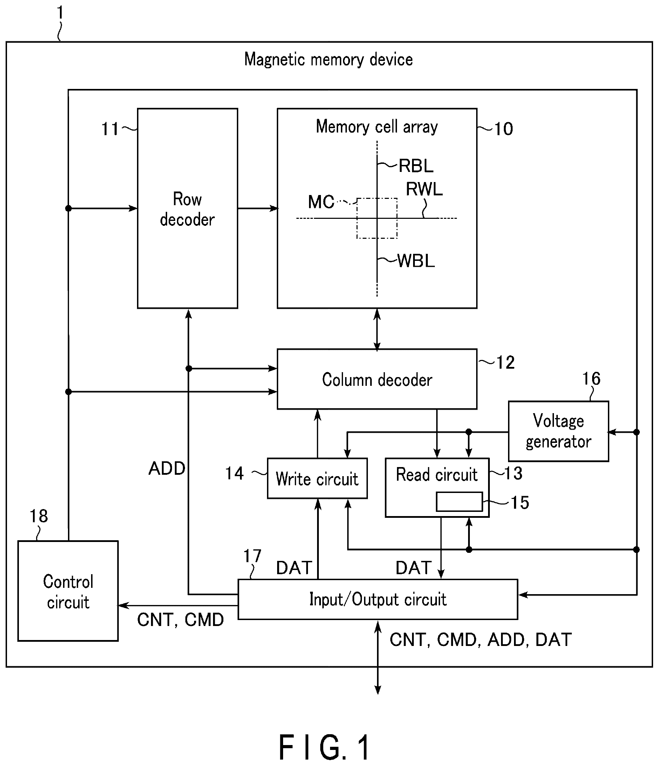

FIG. 1 is a block diagram showing an example of the configuration of the magnetic memory device according to the first embodiment. The magnetic memory device 1 includes a memory cell array 10, a row decoder 11, a column decoder 12, a read circuit 13, a write circuit 14, a sense amplifier 15, a voltage generator 16, an input/output circuit 17, and a control circuit 18.

The memory cell array 10 is a data storage unit in the magnetic memory device 1. The memory cell array 10 includes a plurality of memory cells MC. Each of the plurality of memory cells MC is associated with a pair formed of a row and a column. The memory cells MC in the same row are associated with the same read word line RWL. The memory cells MC in the same column are associated with the same read bit line RBL and the same write bit line WBL.

The row decoder 11 is a circuit that selects a row of the memory cell array 10. The row decoder 11 is coupled to the memory cell array 10 via the read word lines RWL. An address ADD is supplied to the row decoder 11 from the input/output circuit 17. The row decoder 11 decodes the address ADD and selects a read word line RWL corresponding to a row based on the decoding result. In the description below, a read word line RWL that is selected will be referred to as a selected word line RWL. The read word lines RWL other than the selected word line RWL will be referred to as non-selected word lines RWL.

The column decoder 12 is a circuit that selects a column of the memory cell array 10. The column decoder 12 is coupled to the memory cell array 10 via the read bit lines RBL and the write bit lines WBL. An address ADD is supplied to the column decoder 12 from the input/output circuit 17. The column decoder 12 decodes the address ADD and selects a write bit line WBL and a read bit line RBL corresponding to the column based on the decoding result. In the description below, a read bit line RBL that is selected will be referred to as a selected read bit line RBL. In the description below, a write bit line WBL that is selected will be referred to as a selected write bit line WBL. The read bit lines RBL other than the selected write bit line WBL will be referred to as non-selected write bit lines WBL. The read bit lines RBL other than the selected read bit line RBL will be referred to as non-selected read bit lines RBL.

The read circuit 13 reads data from the memory cells MC. The read circuit 13 includes, for example, a sense amplifier 15. The sense amplifier 15 is a circuit that uses a voltage based on the data stored in a memory cell MC of a data read target and outputs data determined to be stored in the memory cell MC of the data read target.

The write circuit 14 includes, for example, a write driver (not shown). The write circuit 14 writes data to the memory cell MC.

The voltage generator 16 generates voltages for various operations of the memory cell array 10 using the power supply voltage provided by a device (not shown) external to the magnetic memory device 1. For example, the voltage generator 16 generates various voltages necessary for a write operation, and supplies the voltages to the write circuit 14. For example, the voltage generator 16 generates various voltages necessary for a read operation, and supplies the voltages to the read circuit 13.

The input/output circuit 17 is responsible for communication with the outside of the magnetic memory device 1. The input/output circuit 17 transfers the address ADD from the outside of the magnetic memory device 1 to the row decoder 11 and the column decoder 12. The input/output circuit 17 transfers a command CMD from the outside of the magnetic memory device 1 to the control circuit 18. The input/output circuit 17 transmits and receives various control signals CNT between the outside of the magnetic memory device 1 and the control circuit 18. The input/output circuit 17 transfers data DAT from the outside of the magnetic memory device 1 to the write circuit 14, and outputs data DAT transferred from the read circuit 13 to the outside of the magnetic memory device 1.

The control circuit 18 includes, for example, a processor such as a central processing unit (CPU), a read only memory (ROM), and a random access memory (RAM). Based on the control signal CNT and the command CMD, the control circuit 18 controls operations of the row decoder 11, column decoder 12, read circuit 13, write circuit 14, voltage generator 16, and input/output circuit 17 that are provided in the magnetic memory device 1.

Next, the configuration of the memory cell array of the magnetic memory device according to the first embodiment will be described.

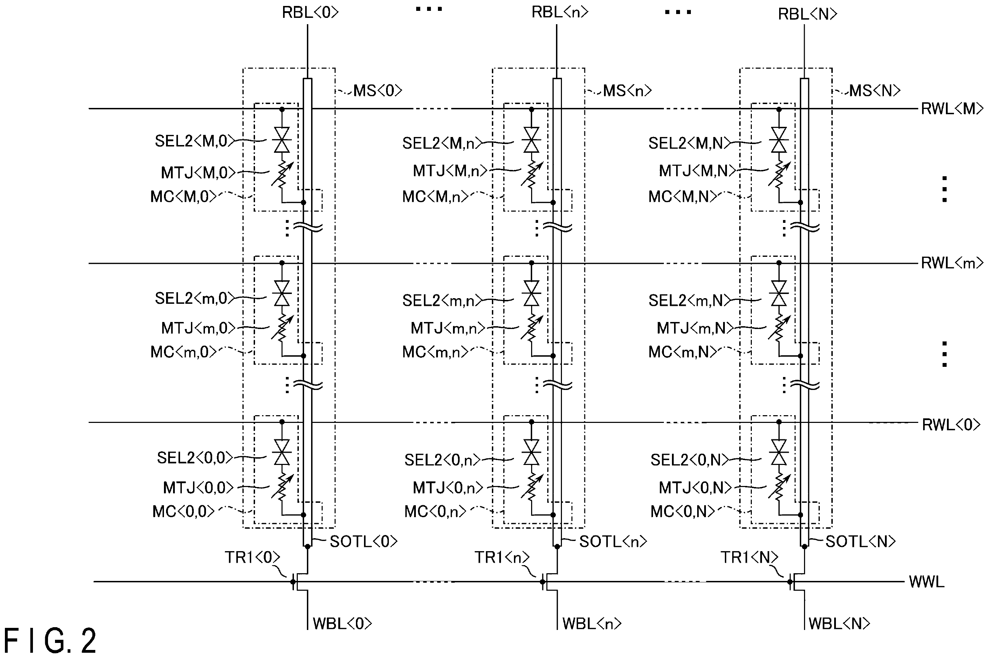

FIG. 2 is a circuit diagram showing an example of the configuration of the memory cell array according to the first embodiment. In FIG. 2, various components are classified and shown by subscripts including indexes ("<>").

The memory cell array 10 includes a plurality of read word lines RWL, a write word line WWL, a plurality of read bit lines RBL, a plurality of write bit lines WBL, a plurality of memory strings MS, and a plurality of switching elements TR1.

The plurality of read word lines RWL include (M+1) read word lines WL<0>, ..., WL<m>, ..., and WL<M>. M is an integer equal to or greater than 1 (0 < m < M).

The plurality of read bit lines RBL include (N+1) read bit lines RBL<0>, ..., RBL<n>, ..., and RBL<N>. N is an integer equal to or greater than 1 (0 < n < N).

The write bit lines WBL include (N+1) write bit lines WBL<0>, ..., WBL<n>, ..., and WBL<N>.

The switching elements TR1 include (N+1) switching elements TR1<0>, ..., TR1<n>, ..., and TR1<N>.

The memory strings MS include (N+1) memory strings MS<0>, ..., MS<n>, ..., and MS<N>. The memory strings MS<0> to MS<N> are similar in configuration. In the following, a description will be given with the memory string MS<n> taken as an example.

The memory string MS<n> includes an interconnect SOTL<n>, and (M+1) memory cells MC<0,n>, ..., MC<m,n>, ..., and MC<M,n>.

The interconnect SOTL<n> has a first end coupled to the read bit line RBL<n>, a second end coupled to a first end of the switching element TR1<n>, and a central portion between these two ends. To the central portion of the interconnect SOTL<n>, (M+1) memory cells MC<0,n>, ..., MC<m,n>, ..., and MC<M,n> are coupled with spacing between them. Part of the interconnect SOTL also functions as part of the memory cell MC<M,n>. In the central portion of the interconnect SOTL<n>, a portion that is coupled to any of the first ends of the memory cells MC<0,n> to MC<M,n> will be referred to as a "cell portion" as well in the description below. In the central portion of the interconnect SOTL<n>, a portion between two adjacent cell portions will be referred to as an "interconnect portion" as well.

The second ends of the memory cells MC<0,n> to MC<M,n> are coupled to the read word lines RWL<0> to RWL<M>, respectively. The memory cells MC<0,n> to MC<M,n> are similar in configuration. In the following, a description will be given with the memory cell MC<m,n> taken as an example.

The memory cell MC<m,n> includes a cell portion of the interconnect SOTL<n> that is coupled to the memory cell MC<m,n>, a switching element SEL2<m,n>, and a magneto-resistive effect element MTJ<m,n>.

The switching element SEL2<m,n> is, for example, a two-terminal switching element. The switching element SEL2<m,n> has a first end coupled to the magneto-resistive effect element MTJ<m,n> and a second end coupled to the read word line RWL<m>. For example, in a case where a voltage applied between the two terminals is lower than a threshold, the switching element SEL2 is in a "high resistance" state, **e.g.,** an electrically non-conductive state (OFF state). In a case where the voltage applied between the two terminals is equal to or higher than the threshold, the switching element SEL2 is in a "low resistance" state, **e.g.,** an electrically conductive state (ON state). The switching element SEL2 may have this function regardless of the polarity of the voltage. In other words, the switching element SEL2 may have the above-mentioned function regardless of the polarity, or both in a case where a positive voltage is applied and in a case where a negative voltage is applied. With the switching element SEL2 turned on or off, control can be performed to determine whether or not a current is supplied to the magneto-resistive effect element MTJ coupled to the switching element SEL2, that is, whether the magneto-resistive effect element MTJ is selected or left non-selected.

The magneto-resistive effect element MTJ<m,n> is coupled in series between the switching element SEL2<m,n> and the cell portion of the interconnect SOTL<n> coupled to the memory cell MC<m,n>. The magneto-resistive effect element MTJ<m,n> is a resistance change element. The magneto-resistive effect element MTJ<m,n> functions as a memory element that stores data in a non-volatile manner by changing its resistance state.

As described above, each memory string MS includes (M+1) memory cells MC coupled to one interconnect SOTL. Therefore, the memory cell array 10 includes (N+1) memory strings MS, and thus includes a total of (M+1)×(N+1) memory cells, specifically, MC<0,0>, ..., MC<0,n>, ..., MC<0,N>, ..., MC<m,0>, ..., MC<m,n>, ..., MC<m,N>, ..., MC<M,0>, ..., MC<M,n>, ..., and MC<M,N>.

Each of the switching elements TR1<0> to TR1<N> is, for example, a three-terminal switching element such as a MOSFET. The switching elements TR1<0> to TR1<N> are similar in configuration. In the following, a description will be given with the switching element TR1<n> taken as an example.

The switching element TR1<n> has a first end coupled to the interconnect SOTL<n>, a second end coupled to the write bit line WBL<n>, and a control end coupled to the write word line WWL. This allows the switching element TR1<n> to control whether or not the voltage applied to the write bit line WBL<n> is transferred to the interconnect SOTL<n>.

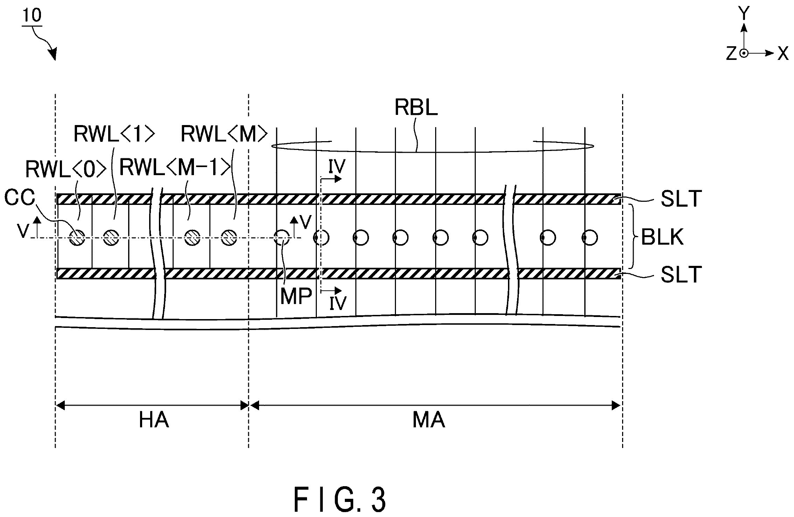

FIG. 3 is an example of a planar layout of the memory cell array 10 of the magnetic memory device 1 according to the first embodiment. FIG. 3 shows an extracted area that functions as one block BLK (or string unit SU). The memory cell array 10 includes a plurality of members SLT, a plurality of memory pillars MP, a plurality of contacts CC, a plurality of read word lines RWL, and a plurality of read bit lines RBL. As shown in FIG. 3, the memory cell array 10 includes, for example, a memory area MA and a hookup area (interconnect hookup area) HA. The memory area MA and the hookup area HA are arranged along the X direction. For example, the hookup area HA is provided at one end on the - X direction side of the memory area MA. The hookup area HA may be provided at each of the ends on the +X direction side and the -X direction side of the memory area MA.

The memory area MA is an area that essentially holds data. The memory area MA is provided with a plurality of memory pillars MP.

The hookup area HA is an area where interconnects and contact plugs are provided for coupling various types of interconnects, which are coupled to the memory pillars in the memory area MA, to the row decoder, for example.

In the hookup area HA, each of the read word lines RWL<0> to RWL<M> has an end portion (terrace portion) that does not overlap the upper interconnect layer (conductive layer). The portions that do not overlap the upper interconnect layers have a staircase shape.

Specifically, a step is provided between the read word line RWL<0> and the read word line RWL<1>, between the read word line RWL<1> and the read word line RWL<2>, ..., between the read word line RWL<M-1> and the read word line RWL<M>.

The plurality of members SLT each extend along the X direction and are arranged in the Y direction. The members SLT have a structure in which an insulating member is filled inside. The members SLT separate conductive layers that are provided in the same interconnect layer and are adjacent to each other, with the members SLT interposed.

Each of the plurality of memory pillars MP functions, for example, as one memory string MS. The plurality of memory pillars MP are arranged, for example, in the X direction in the area between the adjacent members SLT. This structure is not restrictive, and the number and arrangement of the memory pillars MP between adjacent slits can be changed as appropriate.

Each of the memory pillars MP overlaps with one read bit line RBL. For example, the plurality of read bit lines RBL each extend in the Y direction and are arranged in the X direction. The read bit line RBL overlapping the memory pillar MP is electrically coupled to that memory pillar MP.

The plurality of contacts CC are arranged on the terrace portions of the read word lines RWL<0> to RWL<M> in the hookup area HA. The contact plugs CC are made, for example, of phosphorus-doped silicon or a metal material such as tungsten. The read word lines RWL<0> to RWL<M> are electrically coupled to the row decoder 11 via the contacts CC respectively coupled to them. In other words, the row decoder 11 and the stacked interconnects (for example, the read word lines RWL) coupled to the memory strings MS are coupled to each other via the contacts CC.

In the planar layout of the memory cell array 10 of the magnetic memory device 1 described above, the area partitioned by the members SLT functions as one block BLK. In the memory cell array 10, a layout corresponding to one block BLK shown, for example, in FIG. 3 is repeatedly arranged in the Y direction. One memory pillar MP is electrically coupled to one read bit line RBL in each of the spaces partitioned by the members SLT.

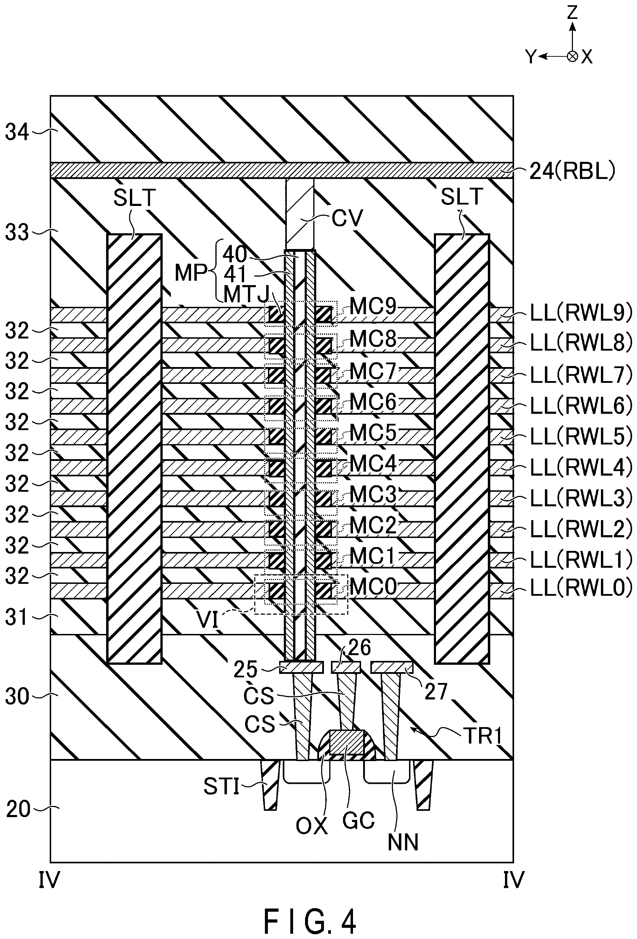

FIG. 4 is a cross-sectional view taken along line IV-IV in FIG. 3 and shows an example of a cross-sectional structure of the magnetic memory device 1 according to the first embodiment. FIG. 4 and onwards show an example in which the number of read word lines RWL is 10 (M=9). As shown in FIG. 4, the magnetic memory device 1 includes a semiconductor substrate 20, conductive layers 24-27, a plurality of stacked interconnect layers LL that function as read word lines RWL0-RWL9, insulating layers 30-34, a plurality of members SLT, a memory pillar MP, contacts CV and CS, and a switching element TR1.

The insulating layer 30 is provided on the semiconductor substrate 20. The insulating layer 30 contains, for example, silicon nitride (SiO₂). Although not fully shown in the drawings, a circuit area is provided in part of the semiconductor substrate 20 and within the insulating layer 30, and the memory cell array 10 is provided above the insulating layer 30. For example, circuits that are used, for example, for the row decoder 11 and the sense amplifier 15 are formed in the circuit area. The circuit area includes a switching element TR1, conductive layers 25 to 27, and a contact CS.

The switching element TR1 includes a gate electrode GC, source/drain regions NN, and an insulating layer OX. The gate electrode GC is provided on the upper face of the semiconductor substrate 20, via a gate insulator interposed. The source/drain regions NN sandwich the area that is below the gate electrode GC in the surface region of the semiconductor substrate 20. The insulating layer OX covers the side face of the gate electrode GC.

One of the source/drain regions NN is coupled to the conductive layer 25 via a columnar contact CS. The other one of the source/drain regions NN is coupled to the conductive layer 27 via the contact CS. The gate electrode GC is coupled to the conductive layer 26 via the contact CS.

The insulating layer 31 is provided on the insulating layer 30. The insulating layer 31 contains, for example, silicon oxide (SiO₂).

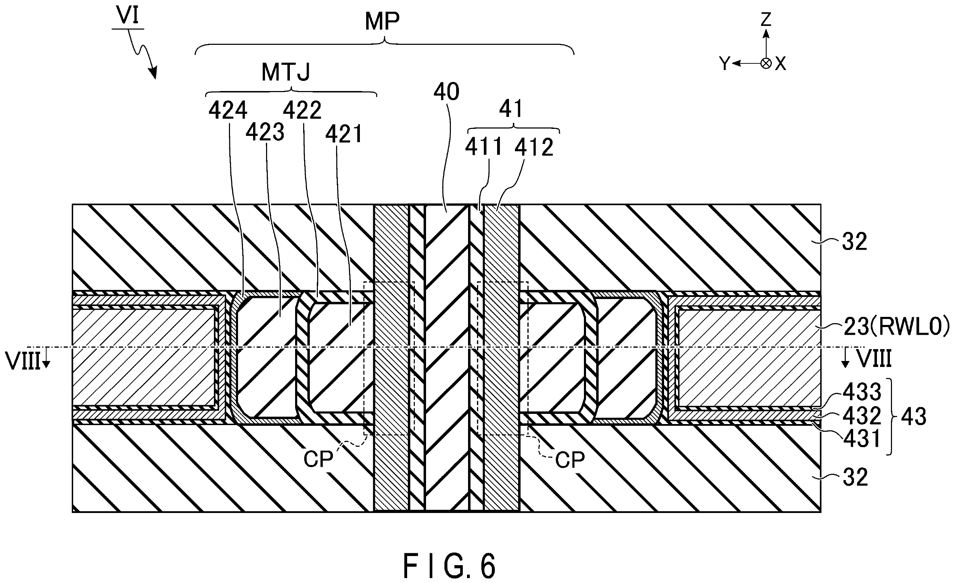

The stacked interconnect layers LL and insulating layers 32 are alternately provided on the insulating layer 31. The stacked interconnect layers LL are each formed, for example, in a plate shape expanding along the XY plane. The plurality of stacked interconnect layers LL are respectively used as read word lines RWL0 to RWL9 in order from the side of the semiconductor substrate 20. Details of the stacked interconnect layers LL will be described later with reference to FIG. 6. The insulating layer 32 contains, for example, silicon oxide.

An insulating layer 33 is provided above the uppermost one of the stacked interconnect layers LL. The insulating layer 33 contains, for example, silicon oxide. A conductive layer 24 is provided on the insulating layer 33. The conductive layer 24 is formed, for example, in a linear shape extending in the Y direction. The conductive layer 24 is used as a read bit line RBL. In an area that is not shown, a plurality of conductive layers 24 are arranged in the X direction. The conductive layers 24 contain copper (Cu), for example.

An insulating layer 34 is provided on the conductive layer 24. The insulating layer 34 contains, for example, silicon oxide. The insulating layer 34 may include an interconnect or the like for coupling the memory cell array 10 to the row decoder 11 and the sense amplifier 15.

Each of the plurality of memory pillars MP extends along the Z direction and penetrates the insulating layers 31-32 and the stacked interconnect layers LL. The upper end of each memory pillar MP is included in the insulating layer 33. The lower end of each memory pillar MP is in contact with the conductive layer 25.

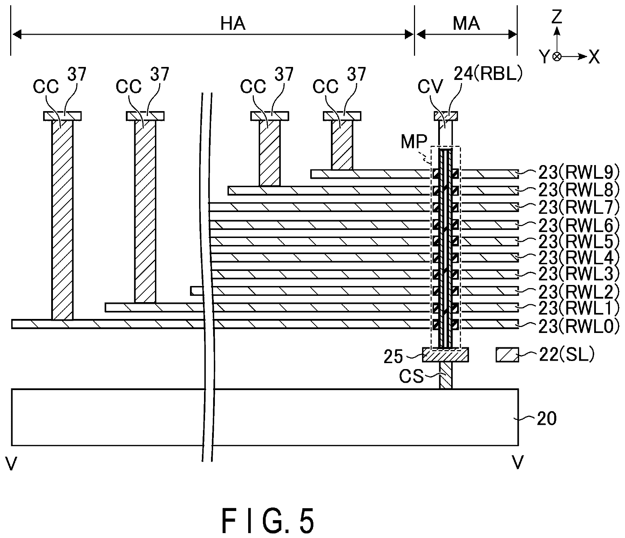

The portions of the memory pillar MP that intersect the stacked interconnect layers LL each function as a cell portion CP (shown in FIG. 6). The shape of the memory pillar MP at the points where it intersects the stacked interconnect layers LL differs from its shape at other points. For example, the diameter of the memory pillar MP at the points where it intersects the stacked interconnect layers LL is larger than its diameter at other points. Details of this will be described later with reference to FIG. 5.

Each of the memory pillars MP includes, for example, a core member 40, an SOT layer 41, and a magneto-resistive effect element MTJ. The core member 40 extends along the Z direction and is provided in the center of the memory pillar MP. For example, the upper end of the core member 40 is included in a layer above the layer in which the uppermost one of the stacked interconnect layers LL is provided. The lower end of the core member 40 is in contact with the conductive layer 25. The core member 40 includes an insulator such as silicon oxide.

The SOT layer 41 covers, for example, the periphery of the core member 40. For example, the bottom face of the SOT layer 41 is in contact with the conductive layer 25. Details of the SOT layer 41 will be described later with reference to FIG. 6.

The magnetic memory device 1 according to the first embodiment may have a structure in which the core member 40 is omitted and the SOT layer 41 is filled in the center. Such a structure will be described later in connection with a modification.

The magneto-resistive effect element MTJ has a cylindrical shape that covers the periphery of the SOT layer 41 at the intersections where the memory pillar MP intersects the stacked interconnect layers LL. Details of the magneto-resistive effect element MTJ will be described later with reference to FIG. 5.

In the structure of the memory pillar MP described above, the intersection of the memory pillar MP with each stacked interconnect layer LL functions as a memory cell MC.

A columnar contact CV is provided on the upper face of the SOT layer 41. The contact CV is electrically coupled to a nonmagnetic layer 412 (described later) in the SOT layer 41.

One conductive layer 24, i.e., one read bit line RBL, is in contact with the upper face of the contact CV. One contact CV is coupled to the conductive layer 24 in each space partitioned by the members SLT. In other words, a memory pillar MP provided between adjacent members SLT is electrically coupled to each conductive layer 24.

Each member SLT has, for example, a plate-shaped portion arranged along the XZ plane, and divides the stacked interconnect layers LL and the insulating layers 31-32 in the Y direction.

The circuit configuration and cross-sectional structure of the magnetic memory device 1 according to the first embodiment are not limited to those described above. In FIG. 2 and the subsequent descriptions, an example is shown in which the switching element TR1 is positioned on the semiconductor substrate 20 provided on the lower side (-Z side) of the stacked interconnect structure, but this is not restrictive. The switching element TR1 may be arranged on the upper side of the stacked interconnect structure, for example.

Furthermore, the switching element TR1 may be composed of a two-terminal switching element.

FIG. 5 is a cross-sectional view taken along line V-V in FIG. 3 and shows an example of a cross-sectional structure of the magnetic memory device 1 according to the first embodiment. As shown in FIG. 5, the magnetic memory device 1 further includes conductive layers 22 and 37.

In the hookup area HA, the ends of the plurality of stacked interconnect layers LL are provided in a staircase manner. In the hookup area HA, the memory cell array 10 further includes a plurality of conductive layers 37.

On each of the terrace portions of the plurality of stacked interconnect layers LL, one contact CC is provided. On each contact CC, one conductive layer 37 is provided, and the contact CC and the conductive layer 37 are electrically coupled to each other.

The conductive layer 22 is provided between the semiconductor substrate 20 and the lowermost conductive layer 23 in the memory area MA. The conductive layer 22 is formed, for example, in a linear shape extending in the Y direction, and is used at least as part of the source line SL. For example, the conductive layer 27 shown in FIG. 4 functions at least as part of the write bit line WBL and is coupled to the conductive layer 22.

It should be noted that configuration of the memory cell array 10 in the hookup area HA is not limited to that described above. For example, the ends of the stacked interconnect layers LL may have steps formed in the Y direction. The ends of the stacked interconnect layers LL in the hookup area HA may be formed like a staircase with any number of columns.

FIG. 6 is an enlarged view of the area VI depicted in FIG. 4 and shows an example of a cross-sectional structure of a memory pillar MP in the magnetic memory device 1 according to the first embodiment. FIG. 6 shows part of the memory pillar MP, and shows the structure of the stacked interconnect layer LL and the structure of the area where the memory pillar MP intersects that stacked interconnect layer LL. The memory pillar MP extends along the Z direction and has a portion that protrudes in the XY direction. The portion that protrudes in the XY direction is a magneto-resistive effect element MTJ.

The SOT layer 41 includes, for example, a nonmagnetic layer 411 and a nonmagnetic layer 412. As described above, the core member 40 extends along the Z direction and is provided in the center of the memory pillar MP. The nonmagnetic layer 411 is provided, for example, on the side face of the core member 40 and has a cylindrical shape, for example. The nonmagnetic layer 411 is a high-resistance conductive film, an insulating film, or a semiconductor having nonmagnetic properties. When the nonmagnetic layer 412 described later is formed, the nonmagnetic layer 411 functions as a protective layer (barrier metal layer) for protecting the nonmagnetic layer 412 from oxidation. The nonmagnetic layer 411 functions as a cap layer for the nonmagnetic layer 412 described later. The nonmagnetic layer 411 contains, for example, tantalum (Ta), tungsten (W), titanium (Ti), or silicon (Si), or a nitride film thereof, such as tantalum nitride (TaN), tungsten nitride (WN), titanium nitride (TiN), or silicon nitride (SiN) from the viewpoint of improving the adhesion of the layer. The nonmagnetic layer 411 may be omitted.

The nonmagnetic layer 412 is provided on the side face of the nonmagnetic layer 411 and has a cylindrical shape, for example. The nonmagnetic layer 412 functions as an interconnect SOTL. A portion of the nonmagnetic layer 412 that intersects the magneto-resistive effect element MTJ is used at least as part of the cell portion CP. A portion of the nonmagnetic layer 412 that does not intersect the magneto-resistive effect element MTJ is used as an interconnect portion.

The nonmagnetic layer 412 contains a heavy metal having nonmagnetic and conductive properties. The nonmagnetic layer 412 contains at least one element selected, for example, from β-Ta, α-tungsten (α-W), β-tungsten (β-W), hafnium (Hf) bismuth (Bi), antimony (Sb), iridium (Ir), platinum (Pt), gold (Au), tellurium (Te), selenium (Se). The nonmagnetic layer 412 contains, for example, BiSb, a Bi alloy, an Sb alloy, Sb with added arsenic (As), an alloy containing tellurium, or an alloy containing selenium. The nonmagnetic layer 412 may be configured as a single layer containing the above-mentioned materials, or may be configured by stacking a plurality of layers containing the above-mentioned materials.

The nonmagnetic layer 412 is a layer that generates a spin-orbit torque (SOT) mainly due to the Spin Hall Effect caused by a current flowing therethrough. The spin-orbit torque acts on an interface of the magneto-resistive effect element MTJ that is in contact with the nonmagnetic layer 412 (a ferromagnetic layer 421 described later). To obtain a large spin-orbit torque, the current flowing through the nonmagnetic layer 412 has to be increased, that is, the current density has to be increased, which increases spin polarization at the interface. To ensure a current density required for magnetization reversal, a thickness (radial thickness) of the nonmagnetic layer 412 in a radial direction is controlled, for example. The radial direction is the direction penetrating the layers cylindrically provided in the memory pillar **MP.** In other words, the radial direction is the direction perpendicular to the circumferential direction of the layers cylindrically provided in the memory pillar **MP.**

The SOT layer 41 may also include a nonmagnetic layer 413 (not shown) positioned between the nonmagnetic layer 412 and the ferromagnetic layer 421 at the interface with the magneto-resistive effect element MTJ. The nonmagnetic layer 413 contains, for example, an oxide or a nitride. The nonmagnetic layer 413 contains, for example, an oxide having an NaCl structure, such as magnesium oxide (MgO), nickel oxide (NiO), or iron oxide (FeO), or a spinel structure oxide, such as cobalt oxide (CoOx), ferrioxide (FeOx), magnesium oxide (Mno), titanium oxide (TiOx), tungsten oxide (WOx), or magnesium aluminum oxide (MgAlO).

The magneto-resistive effect element MTJ includes, for example, a ferromagnetic layer 421, a nonmagnetic layer 422, a ferromagnetic layer 423, and a nonmagnetic layer 424.

The ferromagnetic layer 421 is provided on the side face of the nonmagnetic layer 412 in the layer including the stacked interconnect layers LL, and has a cylindrical shape. The ferromagnetic layer 421 is electrically coupled to the nonmagnetic layer 412. In a case where the nonmagnetic layer 413 is provided, the nonmagnetic layer 413 has a thickness enabling electrical coupling between the nonmagnetic layer 412 and the ferromagnetic layer 421. The ferromagnetic layer 421 is a conductive film having ferromagnetic properties. The ferromagnetic layer 421 is used as a storage layer. The spin-orbit torque generated in the nonmagnetic layer 412 acts on the ferromagnetic layer 421.

The ferromagnetic layer 421 is, for example, a ferromagnetic layer made of a material containing iron (Fe), cobalt (Co) and nickel (Ni), and representative examples of the material include a cobalt-iron alloy (CoFe), cobalt-iron-nickel alloy (CoFeNi), nickel-iron alloy (NiFe), and a cobalt-iron-boron alloy (CoFeB). More specifically, for example, the ferromagnetic layer 421 contains a Co-containing ferromagnetic material, cobalt-iron-nickel alloy (CoFeNi), nickel-iron alloy (NiFe), CoFe, or CoFeB that are formed by atomic layer deposition (ALD) or chemical vapor deposition (CVD). Further, the ferromagnetic layer 421 contains, for example, nickel iron (NiFe), nickel (Ni), or cobalt iron (CoFe) formed by a plating method.

The nonmagnetic layer 422 covers the surface of the ferromagnetic layer 421 except for the portion where the ferromagnetic layer 421 and the nonmagnetic layer 412 are in contact with each other. The nonmagnetic layer 422 is an insulating film having nonmagnetic properties. The nonmagnetic layer 422 is used as a tunnel barrier layer. The nonmagnetic layer 422 is provided between the ferromagnetic layer 421 and the ferromagnetic layer 423, and forms a magnetic tunnel junction together with these two ferromagnetic layers 421 and 423. In other words, a magneto-resistive effect occurs in the magnetic tunnel junction portion.

The nonmagnetic layer 422 contains, for example, boron nitride (BN) or aluminum nitride (AlN). The nonmagnetic layer 422 contains, for example, hexagonal boron nitride (h-BN) or hexagonal aluminum nitride (h-AlN). More specifically, for example, the nonmagnetic layer 422 contains BN or AlN formed by ALD or CVD. The nonmagnetic layer 422 may use an oxide having an NaCl structure, such as magnesium oxide (MgO), aluminum oxide (Al₂O₃), or magnesium aluminum oxide (MgAl₂O₄) having a spinel structure. The nonmagnetic layer 422 may be formed by CVD or ALD.

The ferromagnetic layer 423 is provided on the side face of the nonmagnetic layer 422 and has a cylindrical shape, for example. The ferromagnetic layer 423 is a conductive film having ferromagnetic properties. The ferromagnetic layer 423 is used as a reference layer.

The ferromagnetic layer 423 is made, for example, of a ferromagnetic material containing iron (Fe), cobalt (Co) and Nickel (Ni), and representative examples of the material include a cobalt-iron alloy (CoFe) and a cobalt-iron-boron alloy (CoFeB). More specifically, the ferromagnetic layer 421 contains a Co-containing ferromagnetic material, cobalt-iron-nickel alloy (CoFeNi), nickel-iron alloy (NiFe), CoFe, or CoFeB that are formed by atomic layer deposition (ALD) or chemical vapor deposition (CVD). Further, the ferromagnetic layer 423 contains, for example, nickel iron (NiFe), nickel (Ni), or cobalt iron (CoFe) formed by a plating method.

The nonmagnetic layer 424 covers the surface of the ferromagnetic layer 423 except for the portion where the ferromagnetic layer 423 and the nonmagnetic layer 422 are in contact with each other. The nonmagnetic layer 424 is a conductive film having nonmagnetic properties. The nonmagnetic layer 424 functions as an underlayer for the ferromagnetic layer 423. The nonmagnetic layer 424 can prevent the ferromagnetic layer 423 from directly contacting the stacked interconnect layer LL.

The nonmagnetic layer 424 contains at least one element selected from the group consisting of tantalum (Ta), tungsten (W), and titanium (Ti). More specifically, the nonmagnetic layer 424 contains, for example, tantalum (Ta), tungsten (W), titanium (Ti) formed by ALD or CVD, or nitrides thereof.

A layer containing silicon (Si) may also be provided between the nonmagnetic layer 424 and the stacked interconnect layer LL.

In this manner, the magneto-resistive effect element MTJ has a structure in which, for example, the ferromagnetic layer 421 and the nonmagnetic layer 422 are in contact with the SOT layer 41, and the ferromagnetic layer 423 and the nonmagnetic layer 424 are not in contact with the SOT layer 41. In other words, for example, the ferromagnetic layer 421 is in contact with the nonmagnetic layer 412. The nonmagnetic layer 422 is provided between the insulating layer 32 and the ferromagnetic layer 421 and includes a portion that is in contact with the nonmagnetic layer 412. The ferromagnetic layer 423 is not in contact with the nonmagnetic layer 412. Another structure will be described later in connection with the second embodiment.

The stacked interconnect layer LL includes a conductive layer 23 and a switching layer 43. The conductive layer 23 is provided, for example, in the form of a plate expanding along the XY plane. The conductive layer 23 contains, for example, tungsten (W) or molybdenum (Mo). The conductive layer 23 functions mainly as a read word line RWL.

The switching layer 43 covers the surface of the conductive layer 23 except for the portion where the conductive layer 23 is in contact with a member SLT (not shown). The switching layer 43 includes a portion provided between the conductive layer 23 and the nonmagnetic layer 424 and between the conductive layer 23 and the insulating layer 32. The switching layer 43 includes a layer that functions as a selector of the memory cell MC. That is, the switching layer 43 functions as a switching element SEL2 in the memory cell MC. The switching layer 43 includes an underlayer 431, a variable resistance material layer 432, and a cap layer 433.

The cap layer 433 covers the surface of the conductive layer 23 except for the portion where the conductive layer 23 is in contact with the member SLT (not shown). The cap layer 433 contains, for example, Ta, W, Ti, TaN, WN, TiN, or amorphous carbon (a-C). The cap layer 433 may be configured as a single layer containing the above-mentioned materials, or may be configured as a plurality of stacked layers containing the above-mentioned materials. The cap layer 433 improves, for example, the adhesion between the conductive layer 23 and the switching layer 43. The cap layer 433 functions, for example, as a barrier metal layer for the conductive layer 23. For example, the cap layer 433 can prevent W contained in the conductive layer 23 from diffusing into an adjacent layer, such as the insulating layer 32.

The variable resistance material layer 432 covers the periphery of the cap layer 433 except for the portion where the cap layer 433 is in contact with the member SLT (not shown).

The variable resistance material layer 432 contains at least one chalcogen element selected from the group consisting of tellurium (Te), selenium (Se), and sulfur (S). Alternatively, for example, the variable resistance material layer 432 may contain chalcogenide, which is a compound containing the above-mentioned chalcogen elements. Similarly, the variable resistance material layer 432 may further contain at least one element selected from the group consisting of boron (B), aluminum (Al), gallium (Ga), indium (In), carbon (C), silicon (Si), germanium (Ge), tin (Sn), arsenic (As), phosphorus (P), bismuth (Bi), and antimony (Sb).

The variable resistance material layer 432 may also contain a pn junction material using silicon (Si) and germanium (Ge).

The underlayer 431 covers the periphery of the variable resistance material layer 432 except for the portion where the variable resistance material layer 432 is in contact with the member SLT (not shown). The underlayer 431 is provided, for example, between the variable resistance material layer 432 and the nonmagnetic layer 424 and between the variable resistance material layer 432 and the insulating layer 32. The underlayer 431 contains, for example, Ta, W, Ti, TaN, WN, TiN, or α-C. The underlayer 431 may be configured as a single layer containing the above-mentioned materials, or may be configured by stacking a plurality of layers containing the above-mentioned materials. The underlayer 431 improves, for example, the adhesion between the magneto-resistive effect element MTJ and the switching layer 43. The underlayer 431 can also function, for example, as a barrier metal layer for the conductive layer 23. For example, the underlayer 431 can prevent W contained in the conductive layer 23 from diffusing into the adjacent insulating layer 32.

The switching layer 43 is, for example, a two-terminal switching element, with a first terminal corresponding to a face of the switching layer 43 in which the cap layer 433 is in contact with the conductive layer 23, and a second terminal corresponding to a face of the switching layer 43 in which the underlayer 431 is in contact with the insulating layer 32 and the nonmagnetic layer 424. In a case where the voltage applied between the two terminals is lower than a threshold, the switching element is in a "high resistance" state, for example, an electrically non-conductive state (OFF state). In a case where the voltage applied between the two terminals is equal to or higher than the threshold, the switching element changes to a "low resistance" state, for example, an electrically conductive state (ON state).

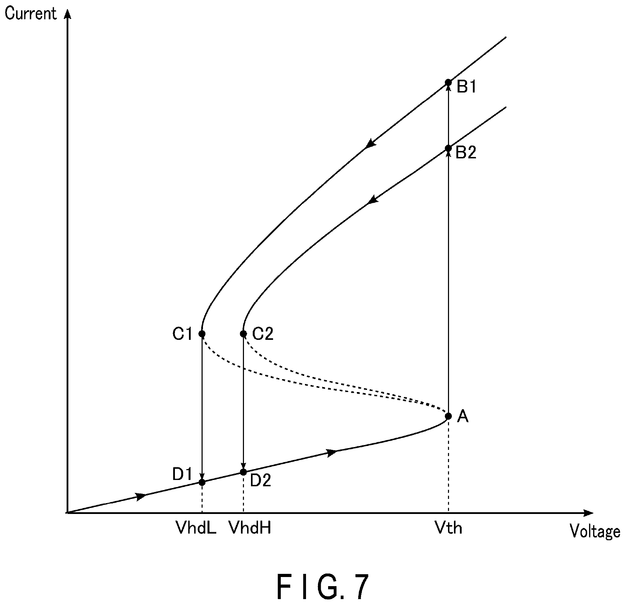

The structure of the switching layer 43 described above is merely an example, and the switching layer 43 may have any other structure as long as it functions as a two-terminal switching element. For example, a snapback switching selector, a nonlinear IV selector, a unipolar diode based on a pn junction, or a bipolar diode may be used for the switching layer 43. In other words, the switching layer 43 may be a selector having nonlinear current-voltage characteristics, a selector having a snapback characteristic, or a diode. An example of the voltage and current characteristics of the memory cell MC, in which a selector with a snapback characteristic is applied to the switching layer 43, will be described later with reference to FIG. 7.

The above-mentioned structure of the magneto-resistive effect element MTJ is merely an example, and the magneto-resistive effect element MTJ may have other structures. For example, the nonmagnetic layer 422 may further have a portion provided on the side face of the nonmagnetic layer 412 in the layer including the insulating layer 32 (the portion may be hereinafter referred to as a nonmagnetic layer 422a). In other words, the nonmagnetic layer 422 may further include a nonmagnetic layer 422a that is a portion sandwiched between the insulating layer 32 and the nonmagnetic layer 412. The nonmagnetic layer 422a may be provided on the entire side face of the nonmagnetic layer 412 in the layer including the insulating layer 32, or may be provided on only part of that side face. In other words, the nonmagnetic layer 422 may be provided continuously in the layer including the insulating layer 32 and in the layer including the stacked interconnect layer LL, or it may not be provided continuously. The magneto-resistive effect element MTJ may include further layers.

FIG. 7 shows an example of curves of voltage and current characteristics of the memory cell of the magnetic memory device according to the first embodiment. The switching element SEL2 (switching layer 43) may have a snapback characteristic as shown in FIG. 7. The horizontal axis of a graph indicates the magnitude of a terminal voltage (that is, a difference in potential between both terminals) of the memory cell MC. The vertical axis of the graph indicates, in a logarithmic scale, the magnitude of a current flowing through the memory cell MC. In FIG. 7, virtual characteristics that do not actually appear are indicated by broken lines. FIG. 7 shows a case in which the memory cell MC is in the low resistance state and a case in which the memory cell MC is in the high resistance state.

When the voltage is increased from 0, the current keeps increasing until it reaches a threshold voltage Vth. Until the voltage reaches the threshold voltage Vth, the switching element SEL2 of the memory cell MC is OFF, that is, is non-conductive.

When the voltage is further increased and the voltage reaches the threshold voltage Vth, that is, reaches a point A, a relation between the voltage and the current shows a discontinuous change and shows characteristics shown at points B1 and B2. The magnitude of the current at the points B1 and B2 is significantly larger than the magnitude of the current at the point A. This rapid change in the current is based on the switching element SEL2 of the memory cell MC being turned on. The magnitude of the current at the points B1 and B2 depends on a resistance state of the MTJ element MTJ of the memory cell MC.

When the voltage is decreased from the state in which the switching element SEL2 is ON, for example, a state in which the voltage and the current indicate a relation shown at the point B1 or B2 and points having a higher voltage than the point B1 or B2, the current keeps decreasing.

When the voltage is further decreased and reaches a certain magnitude, the relation between the voltage and the current shows a discontinuous change. The voltage when the relation between the voltage and the current starts to show discontinuity depends on the terminal voltage of the MTJ element MTJ of the memory cell MC, that is, depends on whether the MTJ element MTJ is in the high resistance state or the low resistance state. When the MTJ element MTJ is in the low resistance state, the relation between the voltage and the current shows discontinuity from a point C1. When the MTJ element MTJ is in the high resistance state, the relation between the voltage and the current shows discontinuity from a point C2. When the voltage reaches the points C1 and C2, the relation between the voltage and the current shows characteristics shown at points D1 and D2. The magnitudes of the currents at the points D1 and D2 are respectively significantly smaller than the magnitudes of the currents at the points C1 and C2. This rapid change in the current is based on the switching element SEL2 of the memory cell MC being turned off.

The terminal voltage at the point D1 of the memory cell MC including the MTJ element MTJ in the low resistance state is referred to as low hold voltage VhdL. The terminal voltage at the point D2 of the memory cell MC including the MTJ element MTJ in the high resistance state is referred to as high hold voltage VhdH.

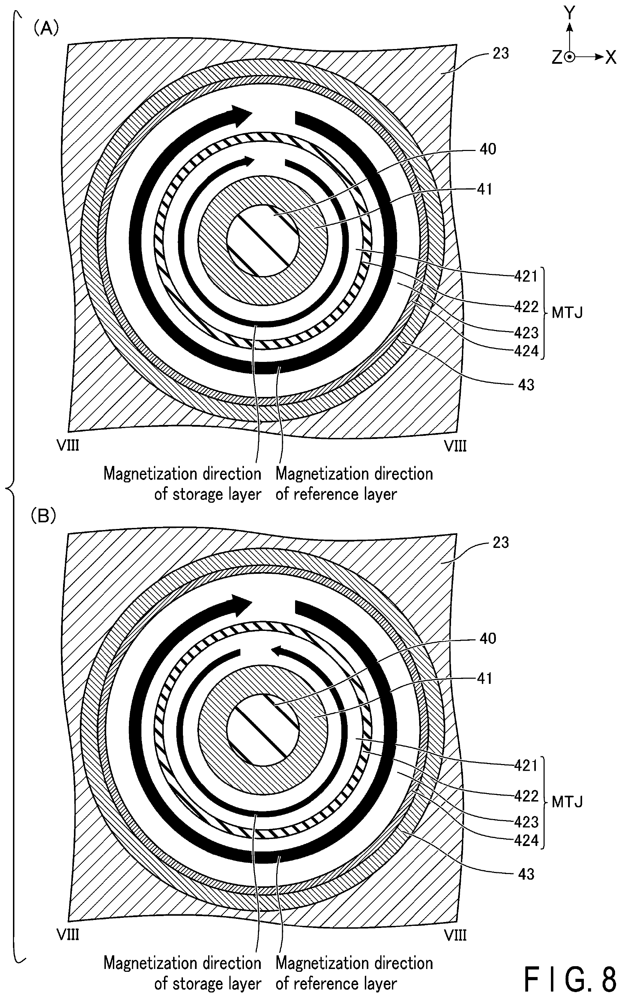

FIG. 8 is a cross-sectional view taken along line VIII-VIII in FIG. 6 and shows an example of the cross-sectional structure of the memory pillar MP in the magnetic memory device 1 according to the first embodiment. Specifically, FIG. 8 shows the cross-sectional structure of the memory pillar MP in a layer parallel to the surface of the semiconductor substrate 20 and including the conductive layer 23. The upper part (A) of FIG. 8 shows an example in which the magneto-resistive effect element MTJ is in the low resistance state. The lower part (B) of FIG. 8 shows an example in which the magneto-resistive effect element MTJ is in the high resistance state.

In the cross section including the conductive layer 23, the memory pillar MP includes a core member 40 in the center. The SOT layer 41 surrounds the side face of the core member 40. The ferromagnetic layer 421 surrounds the side face of the SOT layer 41. The nonmagnetic layer 422 surrounds the side face of the ferromagnetic layer 421. The ferromagnetic layer 423 surrounds the side face of the nonmagnetic layer 422. The nonmagnetic layer 424 surrounds the side face of the ferromagnetic layer 423. The switching layer 43 surrounds the side face of the nonmagnetic layer 424. The conductive layer 23 surrounds the side face of the switching layer 43.

The ferromagnetic layer 423 has an axis of easy magnetization that extends along the shape (or circumference) of the ferromagnetic layer 423 in the XY plane view (top view) from the +Z side. The magnetization direction of the ferromagnetic layer 423 is fixed. It should be noted that the phrase "the magnetization direction is fixed" means that the magnetization direction does not change due to a torque having a magnitude that can reverse the magnetization direction of the ferromagnetic layer 421. In the example in FIG. 8, the magnetization direction of the ferromagnetic layer 423 is clockwise along the axis of easy magnetization in top view.

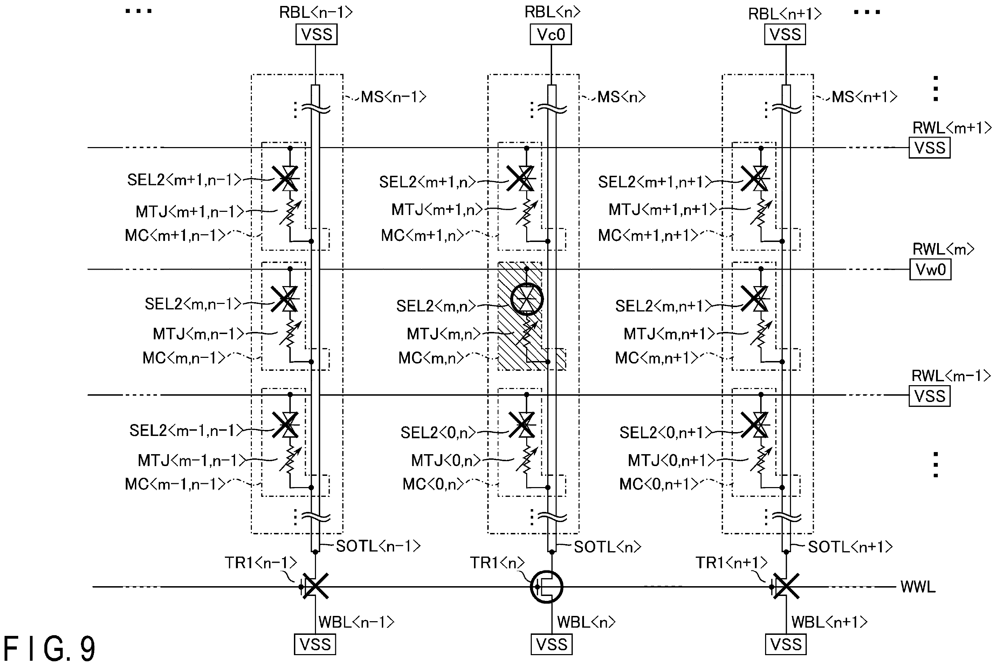

The ferromagnetic layer 421 has an axis of easy magnetization that extends along the shape (or circumference) of the ferromagnetic layer 421 in the XY plan view (top view) from the +Z side. The spin-orbit torque generated in the nonmagnetic layer 412 acts on the ferromagnetic layer 421. The magnetization direction of the ferromagnetic layer 421 is configured to be reversed when a voltage Vw0 or Vw1 (described later with reference to FIG. 9) of a predetermined magnitude is applied and a spin-orbit torque of a predetermined magnitude acts.

The magneto-resistive effect element MTJ can take either the low resistance state or the high resistance state depending on whether the relative relation between the magnetization direction of the storage layer (ferromagnetic layer 421) and the magnetization direction of the reference layer (ferromagnetic layer 423) is parallel or anti-parallel.

The upper part (A) of FIG. 8 shows an example in which the magneto-resistive effect element MTJ is in the low resistance state. In this case, the ferromagnetic layer 421 has magnetization that is oriented clockwise in the XY plane view (top view) from the +Z side. In other words, the relative relation between the magnetization directions of the storage layer (ferromagnetic layer 421) and the reference layer (ferromagnetic layer 423) is parallel. In this parallel state, the resistance value of the magneto-resistive effect element MTJ is lowest, and the magneto-resistive effect element MTJ is in the low resistance state. This low resistance state is referred to as a "P (parallel) state", and is defined, for example, as a state of data "0."

The lower part (B) in FIG. 8 shows an example in which the magneto-resistive effect element MTJ is in the high resistance state. In this case, the ferromagnetic layer 421 has magnetization that is oriented counterclockwise in the XY plane view (top view) from the +Z side. In other words, the relative relation between the magnetization directions of the storage layer (ferromagnetic layer 421) and the reference layer (ferromagnetic layer 423) is antiparallel. In this antiparallel state, the resistance value of the magneto-resistive effect element MTJ is highest, and the magneto-resistive effect element MTJ is in the high resistance state. This high resistance state is referred to as an "AP (Anti-Parallel) state", and is defined, for example, as a state of data "1."

It should be noted that the way in which data "1" and data "0" are defined is not limited to the example described above. For example, the P state may be defined as data "1" and the AP state may be defined as data "0."

Next, the operation of the magnetic memory device according to the first embodiment will be described.

First of all, a first example of a write operation will be described. In the magnetic memory device 1, the magnetization direction of the storage layer relative to the magnetization direction of the reference layer is controlled by utilizing the voltage control of the magnetic anisotropy (VCMA) effect and the spin-orbit torque. Specifically, a write method is adopted that utilizes the VCMA effect generated by applying a voltage to the read word line RWL and the spin-orbit torque generated by causing a current to flow through the interconnect SOTL.

FIG. 9 is a diagram showing an example of voltages that are applied to the memory cell array in the first example of the write operation in the magnetic memory device according to the first embodiment. As the first example of the write operation, FIG. 9 shows a case in which data "0" is written by causing a write current Ic0 to flow through the interconnect SOTL. In FIG. 9, the selected memory cell MC of a write target (i.e., in a selected state) is a memory cell MC<m,n>.

In FIG. 9, part of the memory cell array 10 is shown. That is, the interconnect SOTL<n>, selected read bit line RBL<n>, selected write bit line WBL<n>, and selected read word line RWL<m> that are coupled to the selected memory cell MC<m,n> are shown. In FIG. 9, the interconnects SOTL<n-1> and SOTL<n+1>, the non-selected read bit lines RBL<n-1> and RBL<n+1>, the non-selected write bit lines WBL<n-1> and WBL<n+1> and the non-selected read word lines RWL<m-1> and RWL<m+1> are shown as representatives of the interconnects SOTL, non-selected read bit lines RBL, non-selected write bit lines WBL and non-selected word lines RWL, which are not coupled to the selected memory cell MC<m,n>. In the areas not shown, the states of the interconnects SOTL, non-selected read bit lines RBL, non-selected write bit lines WBL, and non-selected read word lines RWL that are not coupled to the selected memory cell MC<m,n> are the same as the states of the interconnects SOTL<n-1> and SOTL<n+1>, read bit lines RBL<n-1> and RBL<n+1>, write bit lines WBL<n-1> and WBL<n+1>, and read word lines RWL<m-1> and RWL<m+1> as described below.

In FIG. 9, each of the switching elements SEL2 and TR1 in the ON state is marked with a "o", and each of the switching elements SEL2 and TR1 in the OFF state is marked with an "×."

In a case where the first example of the write operation is executed on the selected memory cell MC<m,n>, voltages Vc0 and VSS are applied to the read bit line RBL<n> and the write bit line WBL<n>, respectively. The voltage VSS is 0 V, for example. The voltage Vc0 is a voltage for causing a write current Ic0<n> (not shown) to flow through the interconnect SOTL, and has a magnitude enabling the write current Ic0<n> to flow through the interconnect SOTL. The voltages applied to the read bit line RBL<n> and the write bit line WBL<n> are controlled by the column decoder 12. The voltage VSS is applied to each of the read bit line RBL<n-1> and the write bit line WBL<n-1>. The voltage VSS is applied to each of the read bit line RBL<n+1> and the write bit line WBL<n+1>. Therefore, the write current Ic0 does not flow through any of the interconnects SOTL other than the interconnect SOTL<n>.

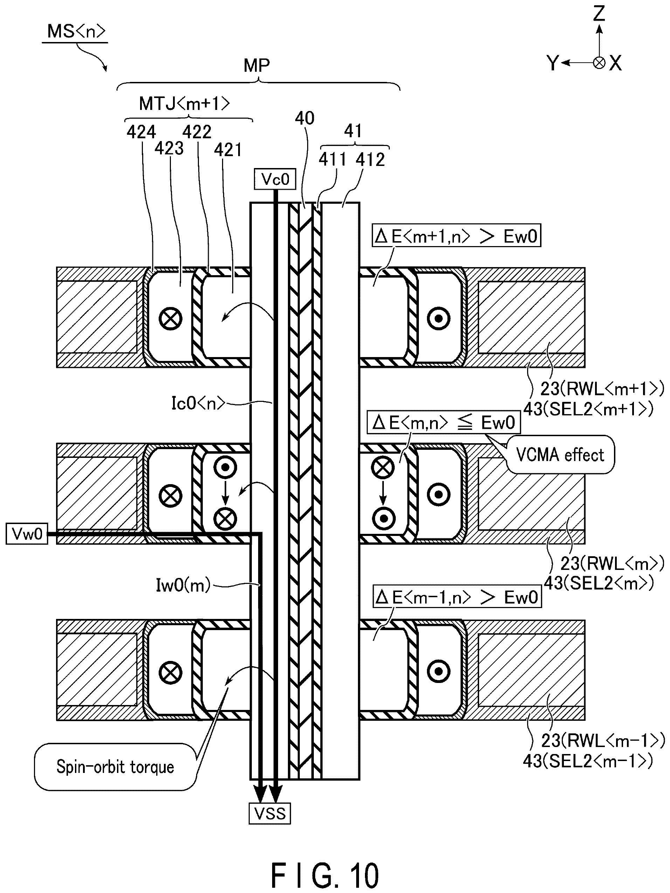

A voltage Vw0 is applied to the selected word line RWL<m>. The voltage Vw0 is, for example, higher than the threshold voltage of the switching element TR1 and lower than the breakdown voltage of the switching element TR1. Details of the voltage Vw0 will be described later with reference to FIG. 10. The voltage applied to the selected word line RWL<m> is controlled by the row decoder 11.

The voltage VSS is applied to the non-selected word lines RWL<m-1> and RWL<m+1>.

With the voltages applied as described above, the switching element SEL2<m,n> is turned on, and the other switching elements SEL2 are all turned off. The switching element TR1<n> is turned on. The other switching elements TR1 are all turned off.

When the voltage Vw0 is applied to the selected read word line RWL<m>, a current Iw0<m> (not shown), for example, flows through the selected write bit line WBL<n> via the selected memory cell MC<m,n>. As described above, the switching element SEL2<m,n> is ON and all other switching elements SEL2 are OFF; therefore, the current Iw0 does not flow through any of the other write bit lines WBL.

FIG. 10 is a diagram showing an example of the current applied to the memory cell array and the magnetization direction during a first example of a write operation performed in the magnetic memory device according to the first embodiment. FIG. 10 shows a memory string MS<n> including a selected memory cell MC<m,n>.

As described above, the voltages Vc0 and VSS are applied to the selected read bit line RBL<n> and the selected write bit line WBL<n>, respectively. Thus, a write current Ic0<n> flows in the -Z direction through the nonmagnetic layer 412, which functions as the interconnect SOTL<n>. When the write current Ic0<n> flows through the nonmagnetic layer 412, it generates a spin-orbit torque that makes the magnetization direction of the ferromagnetic layer 421 parallel to that of the ferromagnetic layer 423. The spin-orbit torque acts on all ferromagnetic layers 421 that are in contact with the nonmagnetic layer 412.

As described above, a voltage Vw0 is applied to the conductive layer 23 functioning as the selected word line RWL<m>. Thus, a current Iw0<m> flows through the nonmagnetic layer 412 in the -Z direction. The current Iw0<m> flows from the conductive layer 23 functioning as the selected read word line RWL<m> to the nonmagnetic layer 412 via the magneto-resistive effect element MTJ<m,n> and the switching element SEL2<m,n>. The current value of the current Iw0<m> is smaller than that of the write current Ic0<n>.

The voltage Vw0 is a voltage that lowers the energy barrier height during the magnetization reversal of the ferromagnetic layer 421 in the magneto-resistive element MTJ<m,n> of the selected memory cell MC<m,n> to a value equal to or less than energy Ew0 due to the VCMA effect, and has a magnitude sufficient to reduce the energy barrier height to the value equal to or less than energy Ew0. The energy barrier height during the magnetization reversal of the ferromagnetic layer 421 in the magneto-resistive effect element MTJ<m,n> may be referred to as an energy barrier height ΔE<m,n> in the description below.

With the voltage Vw0 applied to the conductive layer 23, the energy barrier height ΔE<m,n> lowers to the energy Ew0 or less. The VCMA effect acts only on the ferromagnetic layer 421 on the read word line RWL to which the voltage Vw0 is applied. In other words, the VCMA effect does not act on the ferromagnetic layers 421 of the magneto-resistive effect element MTJ<m-1,n> and the magneto-resistive effect element MTJ<m+1,n>. Therefore, the energy barrier heights ΔE<m-1,n> and ΔE<m+1,n> have values greater than the energy Ew0.

If a write current Ic0 flows through the interconnect SOTL<n> while the energy barrier height ΔE<m,n> is equal to or less than the energy Ew0, the magnetization direction of the ferromagnetic layer 421 becomes parallel to that of the ferromagnetic layer 423 (the state shown in the upper part (A) of FIG. 8) due to the generated spin-orbit torque. In other words, the magnetization direction of the ferromagnetic layer 421 of the selected memory cell MC<m,n> is reversed and becomes parallel to that of the ferromagnetic layer 423. For example, the VCMA effect by the voltage Vw0 increases the speed at which the magnetization direction of the ferromagnetic layer 421 of the selected memory cell MC<m,n> is reversed due to the spin-orbit torque.

Furthermore, while the energy barrier height ΔE is greater than the energy Ew0, as in E<m-1,n> and ΔE<m+1,n> shown in FIG. 10, the magnetization direction of the ferromagnetic layer 421 is not reversed even if a write current Ic0 flows through the interconnect SOTL<n> (even if a spin-orbit torque acts).

By the operation described above, data "0" is written to the selected memory cell MC<m,n>.

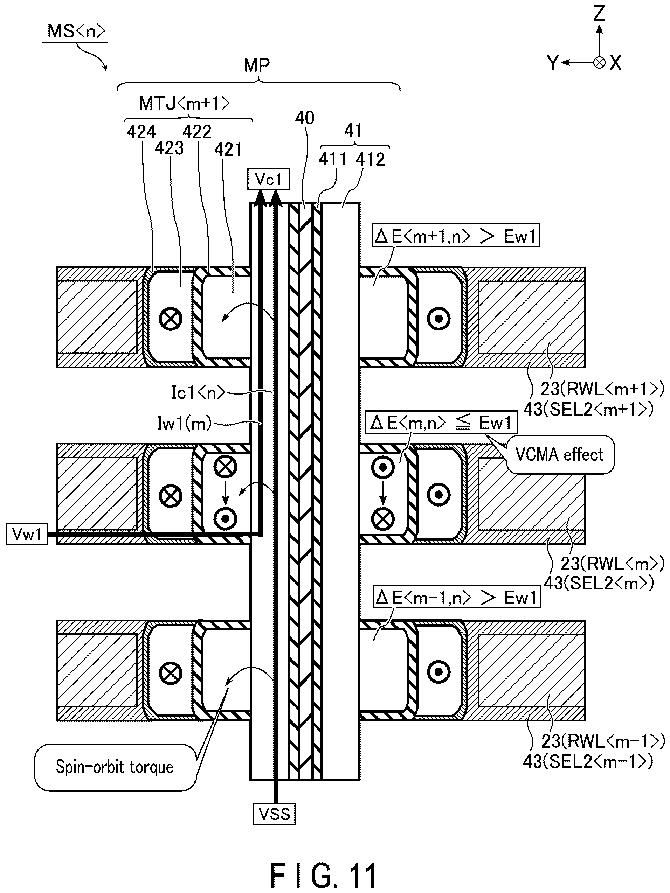

Next, a second example of the write operation will be described. FIG. 11 is a diagram showing an example of the current applied to the memory cell array and the magnetization direction in the second example of the write operation performed in the magnetic memory device according to the first embodiment. FIG. 11 corresponds to FIG. 10 as referenced in the first example of the write operation. As the second example of the write operation, FIG. 11 shows a case in which data "1" is written by causing a write current Ic1 to flow through the interconnect SOTL.

In a case where the second example of the write operation is performed on the selected memory cell MC<m,n>, the on or OFF state of the switching element SEL2 is the same as that shown in FIG. 9 as referenced in connection with the first example of the write operation. During the second example of the write operation, the memory strings MS other than the memory string MS<n> are the same as those during the first example of the write operation; therefore, a description thereof will be omitted.

The voltages VSS and Vc1 are applied to the selected read bit line RBL<n> and the selected write bit line WBL<n>, respectively. Thus, a write current Ic1<n> flows in the +Z direction through the nonmagnetic layer 412 functioning as the interconnect SOTL<n>. When the write current Ic1<n> flows through the nonmagnetic layer 412, a spin-orbit torque is generated, which makes the magnetization direction of the ferromagnetic layer 421 antiparallel to the magnetization direction of the ferromagnetic layer 423. The spin-orbit torque acts on all ferromagnetic layers 421 that are in contact with the nonmagnetic layer 412.

A voltage Vw1 is applied to the conductive layer 23 functioning as the selected word line RWL<m>. The voltage Vw1 is, for example, higher than the threshold voltage of the switching element TR1 and lower than the breakdown voltage of the switching element TR1. Thus, a current Iw1<m> flows through the nonmagnetic layer 412 in the +Z direction. The current Iw1<m> flows from the conductive layer 23 functioning as the selected read word line RWL<m> to the nonmagnetic layer 412 via the magneto-resistive effect element MTJ<m,n> and the switching element SEL2<m,n>. The current value of the current Iw1<m> is smaller than the current value of the write current Ic1<n>.

The voltage Vw1 is a voltage for lowering the energy barrier height ΔE<m,n> to the energy Ew1 or less due to the VCMA effect, and has a magnitude enabling the energy barrier height ΔE<m,n> to lower to the energy Ew1 or less.

With the voltage Vw1 applied to the conductive layer 23, the energy barrier height ΔE<m,n> lowers to the energy Ew1 or less. The VCMA effect acts only on the ferromagnetic layer 421 on the read word line RWL to which the voltage Vw1 is applied. In other words, the VCMA effect does not act on the ferromagnetic layers 421 of the magneto-resistive effect element MTJ<m-1,n> and the magneto-resistive effect element MTJ<m+1,n>. Therefore, the energy barrier heights ΔE<m-1,n> and ΔE<m+1,n> are values greater than the energy Ew1.

If a write current Ic1 flows through the interconnect SOTL<n> while the energy barrier height ΔE<m,n> is equal to or less than the energy Ew1, the magnetization direction of the ferromagnetic layer 421 becomes antiparallel to that of the ferromagnetic layer 423 (the state shown in the lower part (B) of FIG. 8) due to the generated spin-orbit torque. In other words, the magnetization direction of the ferromagnetic layer 421 of the selected memory cell MC<m,n> is reversed and becomes antiparallel to that of the ferromagnetic layer 423. For example, the VCMA effect of the voltage Vw1 increases the speed at which the magnetization direction of the ferromagnetic layer 421 of the selected memory cell MC<m,n> is reversed due to the spin-orbit torque.

Furthermore, while the energy barrier height ΔE is greater than the energy Ew1, as in E<m-1,n> and ΔE<m+1,n> shown in FIG. 11, the magnetization direction of the ferromagnetic layer 421 is not reversed even if a write current Ic1 flows through the interconnect SOTL<n> (even if a spin-orbit torque acts).

By the operation described above, data "1" is written to the selected memory cell MC<m,n>.

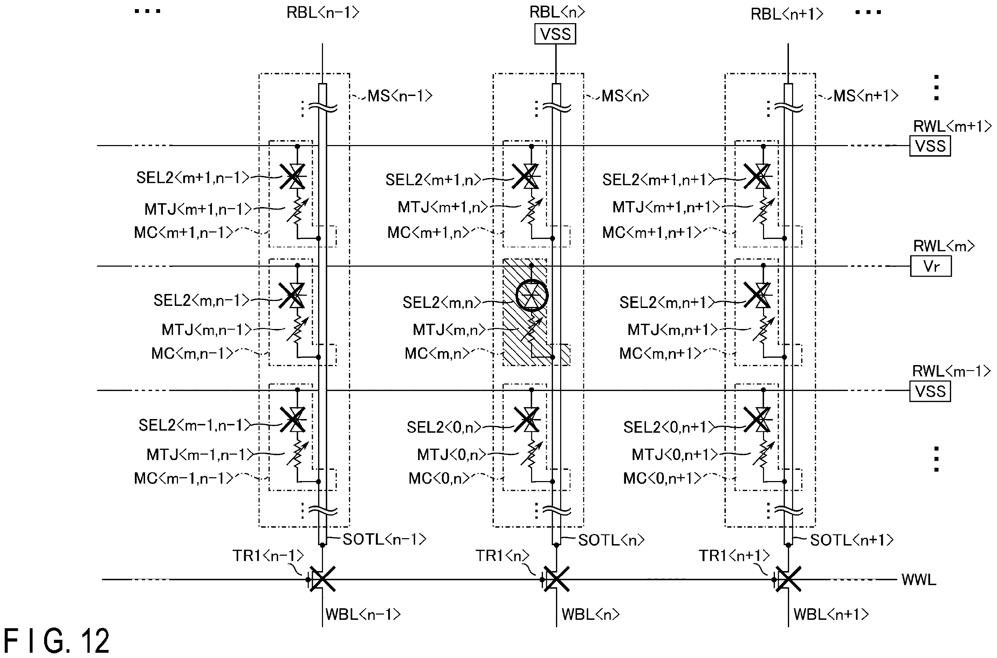

Next, a read operation will be described. FIG. 12 is a diagram showing an example of voltages that are applied to the memory cell array during a read operation performed in the magnetic memory device according to the first embodiment. In the example in FIG. 12, data is read from a memory cell MC<m,n>. The interconnect SOTL<n>, selected read bit line RBL<n>, selected write bit line WBL<n>, and selected read word line RWL<m>, which are coupled to the selected memory cell MC<m,n>, are shown. As in the case of FIG. 9, the interconnects SOTL<n-1> and SOTL<n+1>, the non-selected read bit lines RBL<n-1> and RBL<n+1>, the non-selected write bit lines WBL<n-1> and WBL<n+1>, and the non-selected read word lines RWL<m-1> and RWL<m+1> are shown as representatives. As in the case of FIG. 9, an example of voltages applied to each interconnect are shown. As in the case of FIG. 9, each of the switching elements SEL2 and TR1 in the ON state is marked with an "o", and each of the switching elements SEL2 and TR1 in the OFF state is marked with an "×."

When a read operation is performed on the selected memory cell MC<m,n>, the selected read bit line RBL<n> and the selected write bit line WBL<n> are kept selected by the column decoder 12, and the voltage VSS is applied to the selected read bit line RBL<n>. A voltage that turns off all of the switching elements TR1 is applied to the write word line WWL. Since the switching element TR1 is in the OFF state, any voltage can be applied to the selected write bit line WBL<n>. Then, the non-selected read bit line RBL<n-1> and the non-selected write bit line WBL<n-1> are left non-selected by the column decoder 12, and are in an electrically floating state. Similarly, the non-selected read bit line RBL<n+1> and the non-selected write bit line WBL<n+1> are left in the non-selected state by the column decoder 12 and are in an electrically floating state.

A voltage Vr is applied to the selected word line RWL<m>. The voltage Vr is, for example, higher than the threshold voltage of the switching element TR1 and lower than voltages Vw0 and Vw1. A voltage VSS is applied to the non-selected word lines RWL<m-1> and RBL<m+1>, which are located on both sides of the selected word line RWL<m>.

With the voltages applied as described above, the switching element SEL2<m,n> is turned on, and all other switching elements SEL2 are turned off. All switching elements TR1 are turned off.

When a voltage Vr is applied to the selected read word line RWL<m>, for example, a read current Ir<m> (not shown) flows through the selected read bit line RBL<n> via the selected memory cell MC<m,n>. The current value of the read current Ir<m> is smaller than the current values of the write currents Ic0<n> and Ic1<n>. As described above, the switching element SEL2<m,n> is ON, and all other switching elements SEL2 are OFF, so that the read current Ir does not flow through any of the other selected read bit lines RBL.

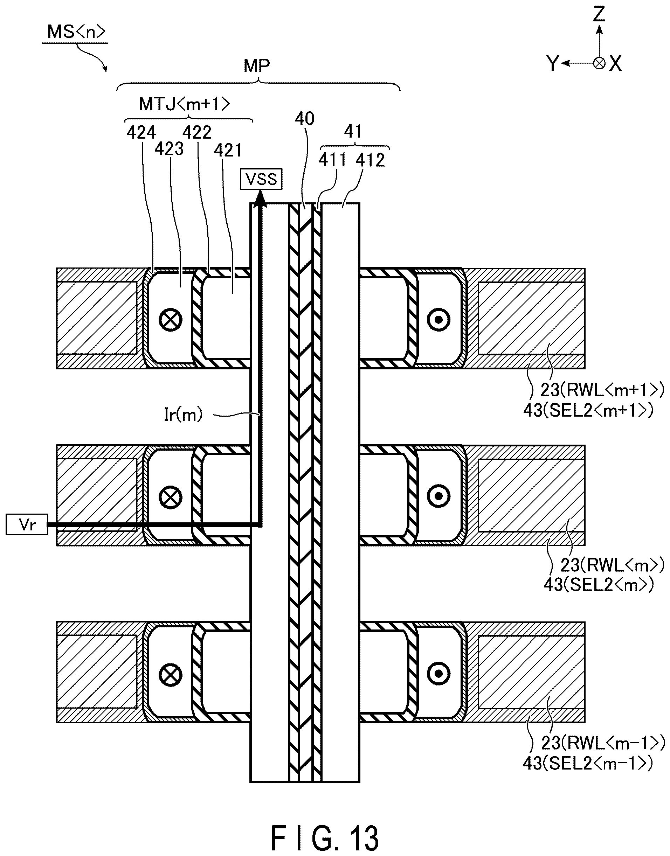

FIG. 13 is a diagram showing an example of currents that are applied to the memory cell array during a read operation performed in the magnetic memory device according to the first embodiment. FIG. 13 shows a memory string MS<n> including a memory cell MC<m,n> of a read target (i.e., in a selected state).

As described above, the voltage Vr is applied to the conductive layer 23 functioning as the selected word line RWL<m>. Thus, a read current Ir<m> flows through the nonmagnetic layer 412 in the +Z direction. The read current Ir<m> flows from the conductive layer 23 functioning as the selected read word line RWL<m> to the nonmagnetic layer 412 via the magneto-resistive effect element MTJ<m,n> and the switching element SEL2<m,n>.

Since the read current Ir flows through the magneto-resistive effect element MTJ, the read circuit 13 can determine whether the magneto-resistive effect element MTJ is in the high resistance state or the low resistance state, based on the read current Ir. The read current Ir is controlled to be smaller than the write currents Ic0 and Ic1.

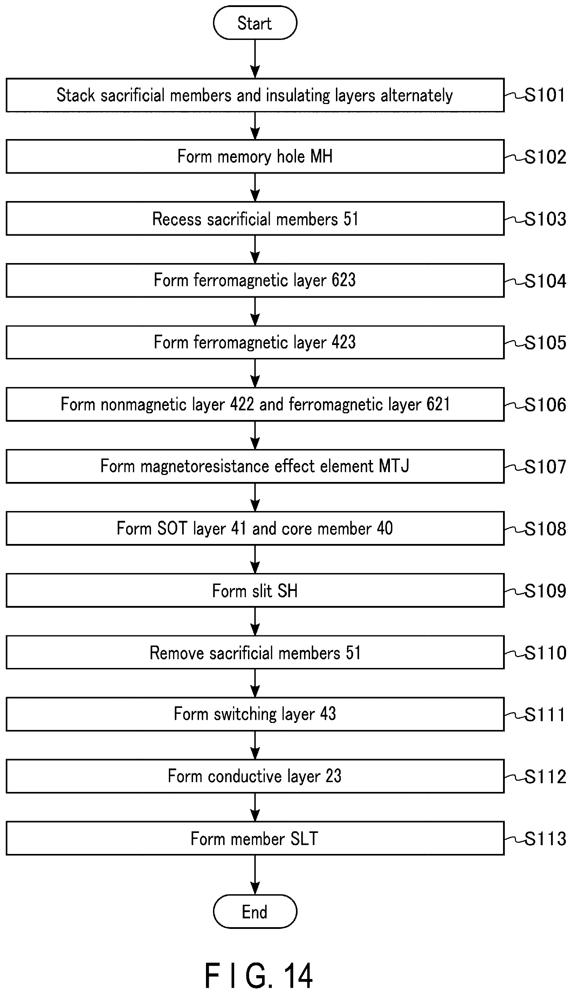

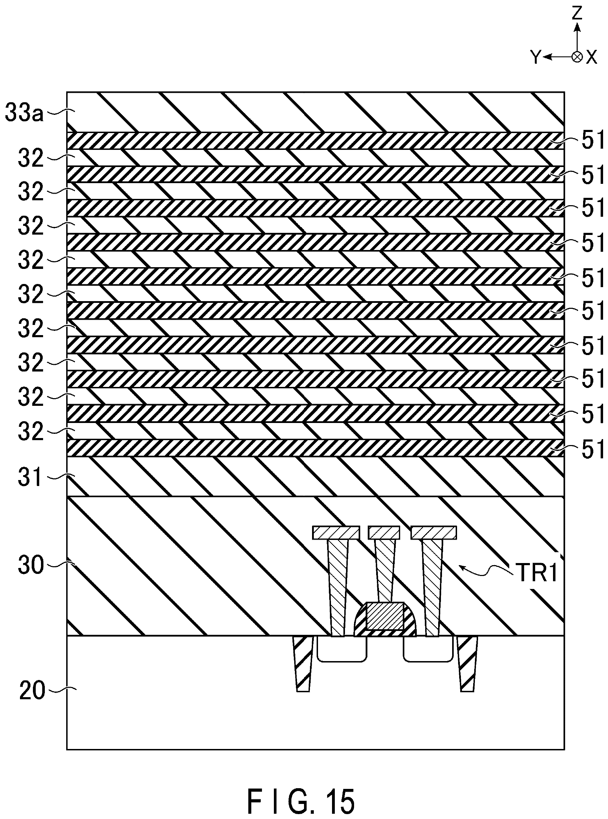

Next, a method for manufacturing the magnetic memory device according to the first embodiment will be described. FIG. 14 is a flowchart showing an example of the method for manufacturing the magnetic memory device according to the first embodiment. Each of FIG. 15 to FIG. 27 shows an example of a cross-sectional structure during manufacturing of the magnetic memory device 1 according to the first embodiment. Each of FIG. 15 to FIG. 27 shows an area including part of the area depicted in FIG. **4****.** In the following, an example of the manufacturing process for forming a stacked interconnect structure in the memory cell array 10 of the magnetic memory device 1 according to the first embodiment will be explained with reference to FIG. 14 as appropriate. As shown in FIG. 14, the method for manufacturing the magnetic memory device 1 according to the first embodiment sequentially performs the processes of steps S101 to S113, for example.

In the process of step S101, sacrificial members and insulating layers are alternately stacked, as shown in FIG. 15. First, an insulating layer 30 and an insulating layer 31 are sequentially formed on the semiconductor substrate 20. In part of the semiconductor substrate 20 and in the insulating layer 30, a switching element TR1, conductive layers 25 to 27, and a contact CS are formed. On the insulating layer 31, sacrificial members 51 and insulating layers 32 are alternately stacked. An insulating layer 33a is formed on the uppermost one of the sacrificial members 51. Each of the insulating layers 30 to 33a and the sacrificial members 51 is formed, for example, by ALD or CVD.

The sacrificial members 51 are formed in an area where stacked interconnect layers LL that function as read word lines RWL are to be formed. For example, the number of layers in which the sacrificial members 51 are formed is equal to the number of read word lines RWL. Each of the insulating layers 30 to 33a contains, for example, silicon oxide. The sacrificial members 51 contain, for example, silicon nitride.

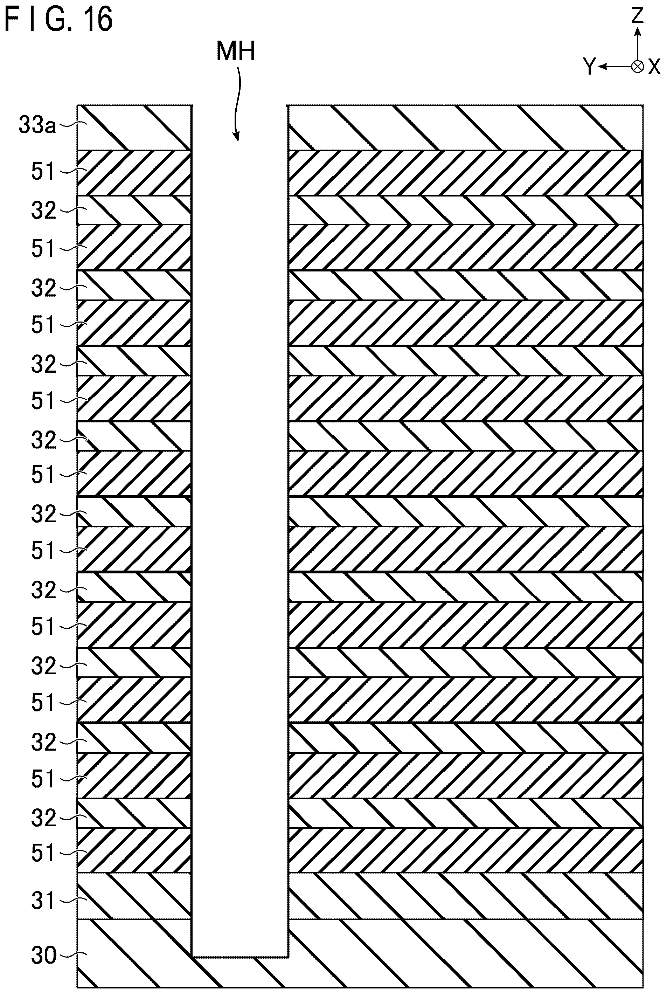

In the process of step S102, a hole MH is formed, as shown in FIG. 16. FIG. 16 shows an area including part of the area depicted in FIG. 15, and in FIG. 16 and subsequent figures, illustration of the semiconductor substrate 20, the switching element TR1, the conductive layers 25 to 27, and the contact CS is omitted. For example, the hole MH is formed by reactive ion etching (RIE). The hole MH penetrates each of the insulating layers 31 to 33a and the sacrificial members 51. The bottom of the hole MH reaches the conductive layer 25 formed in the insulating layer 30.

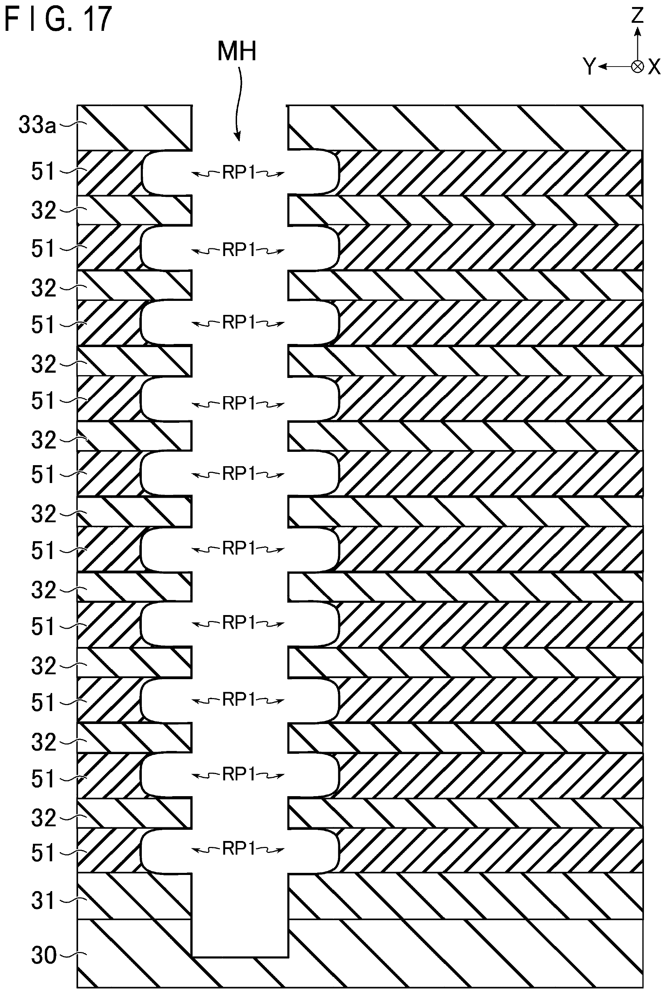

In the process of step S103, a portion of each sacrificial member 51 is recessed, as shown in FIG. 17. FIG. 17 shows a cross-sectional view of the same area as depicted in FIG. 16. Specifically, wet etching is performed through the hole MH to remove a portion of each of the plurality of the sacrificial members 51 exposed on the side face of the hole MH. The etching solution contains phosphoric acid (H₃PO₄), for example. Thus, the side face of the hole MH is processed such that it has a shape in which the sacrificial members 51 are partially removed. The spaces generated by removing a portion of the sacrificial members 51 in this process may be referred to as spaces RP1 in the description below. Each of the spaces RP1 is an area in which, for example, a magneto-resistive effect element MTJ or the like is to be formed.

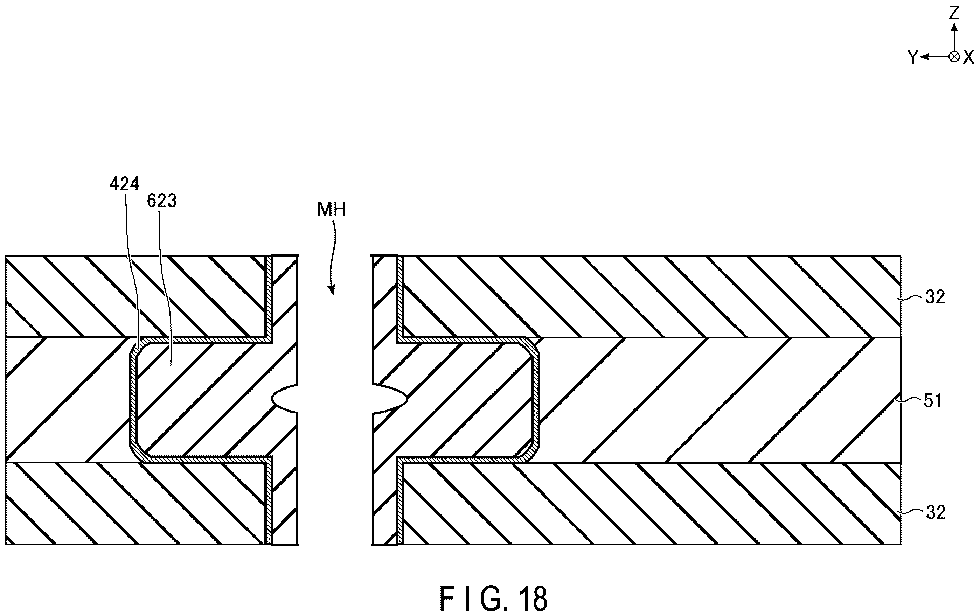

In the process of step S104, a ferromagnetic layer 623 is formed, as shown in FIG. 18. FIG. 18 shows an area including a portion of the area depicted in FIG. 17. FIG. 18 shows a portion of the hole MH, and shows the structure of the sacrificial member 51 and the structure of the area where the hole MH intersects the sacrificial member 51. First, a nonmagnetic layer 424 is formed on the surface and bottom face of the hole MH and on the face exposed in the space RP1. Next, a ferromagnetic layer 623 is formed on the surface of the nonmagnetic layer 424. For example, the ferromagnetic layer 623 fills the space RP1. The nonmagnetic layer 424 and the ferromagnetic layer 623 are formed, for example, by ALD or CVD. A ferromagnetic layer 423 is formed from a portion of the ferromagnetic layer 623 by performing the process described below.

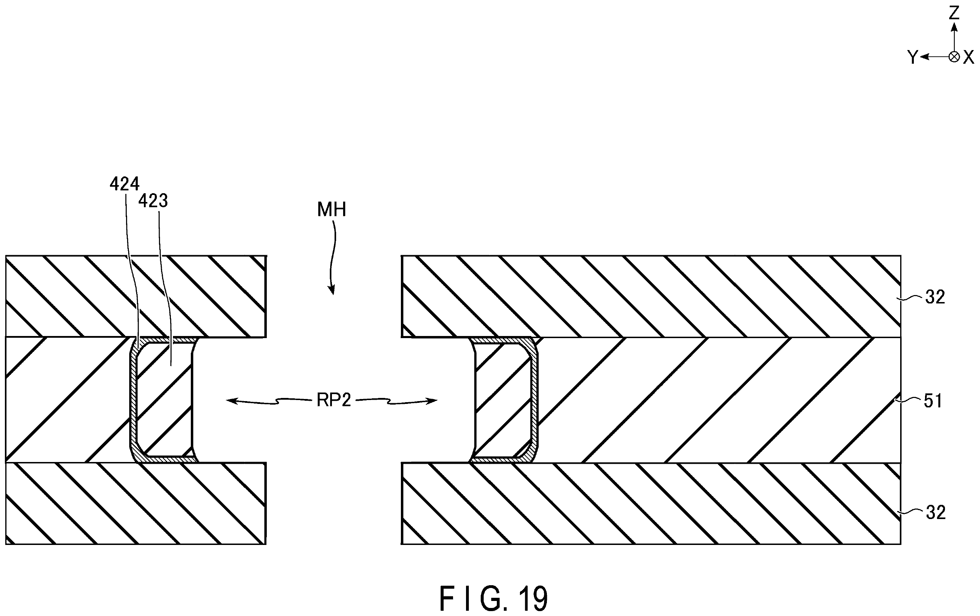

In the process of step S105, the ferromagnetic layer 423 is formed, as shown in FIG. 19. FIG. 19 to FIG. 22 each show a cross-sectional view of the same area as FIG. 18. Wet etching is performed through the hole MH. The wet etching solution etches the ferromagnetic layer 623 and the nonmagnetic layer 424 formed in the hole MH. That is, the ferromagnetic layer 623 and nonmagnetic layer 424 formed on the side face of the insulating layer 32 are removed.

Each of the ferromagnetic layer 623 and the nonmagnetic layer 424 formed in the layer including the sacrificial member 51 is partially removed. The space generated by removing the ferromagnetic layer 623 and the nonmagnetic layer 424 from the layer including the sacrificial member 51 in this process may be hereinafter referred to as a space RP2. The space RP2 is part of the space RP1 that is exposed again. Thus, the side face of the hole MH is processed such that it has a shape in which the ferromagnetic layer 623 and the nonmagnetic layer 424 formed in step S104 are partially removed. The ferromagnetic layer 623 subjected to the etching process will be referred to as a ferromagnetic layer 423. In other words, the ferromagnetic layer 423 is formed by etching the ferromagnetic layer 623.

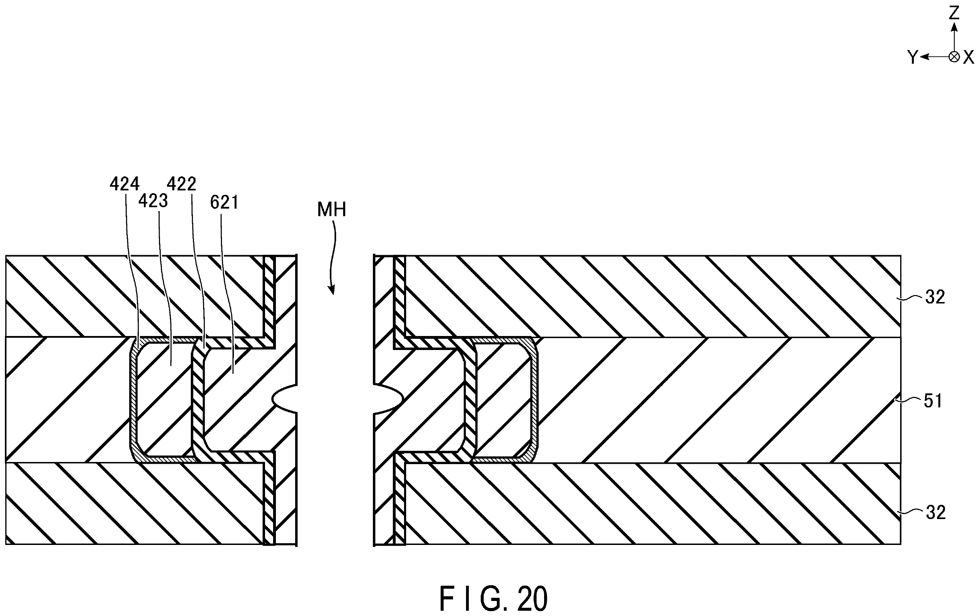

In the process of step S106, a nonmagnetic layer 422 and a ferromagnetic layer 621 are formed, as shown in FIG. 20. Specifically, an oxide film or the like that is unintentionally formed on the surface of the ferromagnetic layer 423 in the process of step S105 is first removed. Next, the nonmagnetic layer 422 is formed on the surface of the ferromagnetic layer 423. Next, the ferromagnetic layer 621 is formed on the surface of the nonmagnetic layer 422. For example, the nonmagnetic layer 422 and the ferromagnetic layer 621 fill the space RP2. The nonmagnetic layer 422 and the ferromagnetic layer 621 are successively formed in a single vacuum process using ALD or CVD. A ferromagnetic layer 421 is formed from a portion of the ferromagnetic layer 621 by performing the process described below.

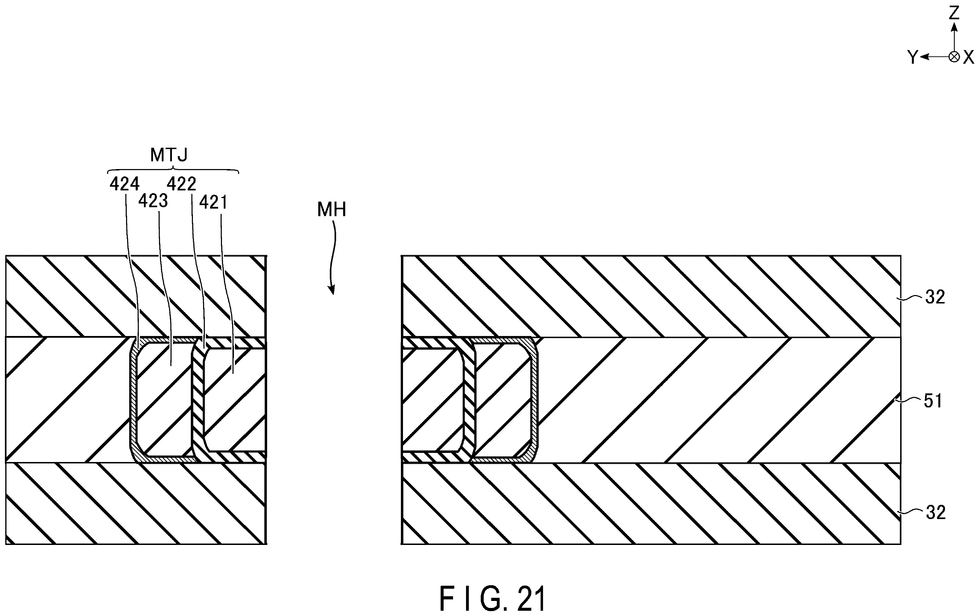

In the process of step S107, a magneto-resistive effect element MTJ is formed, as shown in FIG. 21. Specifically, wet etching is performed through the hole MH. The wet etching solution etches the ferromagnetic layer 621 and the nonmagnetic layer 422 formed in the hole MH. That is, the ferromagnetic layer 621 and nonmagnetic layer 422 formed on the side face of the insulating layer 32 are removed. The ferromagnetic layer 621 subjected to the etching process will be referred to as a ferromagnetic layer 421. In other words, the ferromagnetic layer 421 is formed by etching the ferromagnetic layer 621.

Ideally, the size of the outer periphery of the hole MH is approximately the same in the layer including the insulating layer 32 and in the layer including the sacrificial member 51. That is, ideally, the position of the side face of the ferromagnetic layer 421 exposed in the hole MH and the position of the side face of the insulating layer 32 exposed in the hole MH are approximately aligned in the Z direction (viewed in the XY plane). However, for example, due to the difference in etching rates between the insulating layer 32 and the ferromagnetic layer 421, there may be variations in the size of the outer periphery of the hole MH. For example, the outer periphery of the hole MH may be formed larger in the layer including the sacrificial member 51 than in the layer including the insulating layer 32.

In connection with FIG. 21, a case was described where the nonmagnetic layer 422 formed on the side face of the insulating layer 32 is removed, but part or all of the nonmagnetic layer 422 may remain. On the side face of the insulating layer 32, it is sufficient for the ferromagnetic layer 621 to be removed.

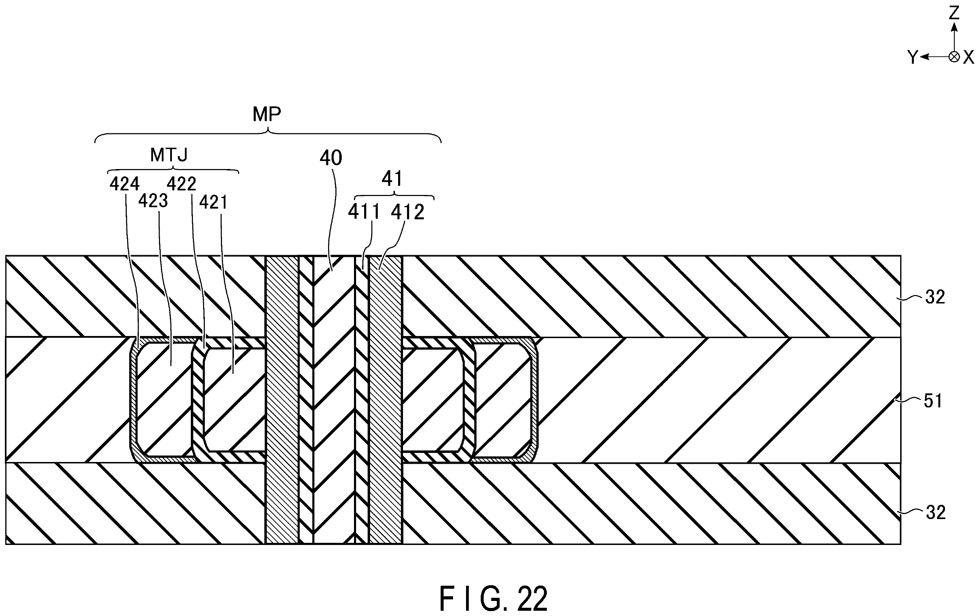

In the process of step S108, an SOT layer 41 and a core member 40 are formed, as shown in FIG. 22. Specifically, a nonmagnetic layer 412 is first formed on the exposed face of the hole MH. The lower end of the nonmagnetic layer 412 is in contact with a conductive layer 25 (not shown) within the insulating layer 30. Next, a nonmagnetic layer 411 is formed on the surface of the nonmagnetic layer 412. Next, the hole MH is filled with the core member 40. The nonmagnetic layer 412, the nonmagnetic layer 411, and the core member 40 are formed, for example, by ALD or CVD. Thus, a memory pillar MP is formed.

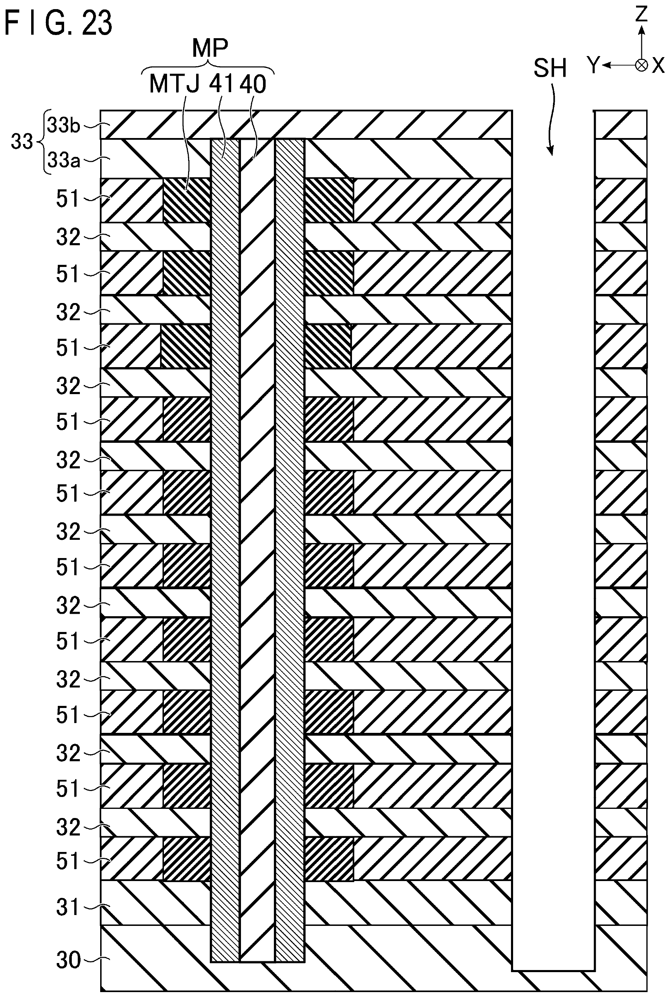

In the process of step S109, a slit SH is formed, as shown in FIG. 23. FIG. 23 shows a cross-sectional view of the same area as depicted in FIG. 16. First, an insulating layer 33b is formed on the upper faces of an insulating layer 33a and the memory pillar MP. In the description below, the layer consisting of the insulating layer 33a and the insulating layer 33b may be referred to as an insulating layer 33. The slit SH is formed in the area where a member SLT is to be formed. Specifically, a mask having an opening in the area corresponding to the slit SH is formed by photolithography or the like, and the slit SH is formed by anisotropic etching using the mask. For example, the slit SH divides the insulating layers 31 to 33 and the sacrificial members 51, and reaches the insulating layer 30.

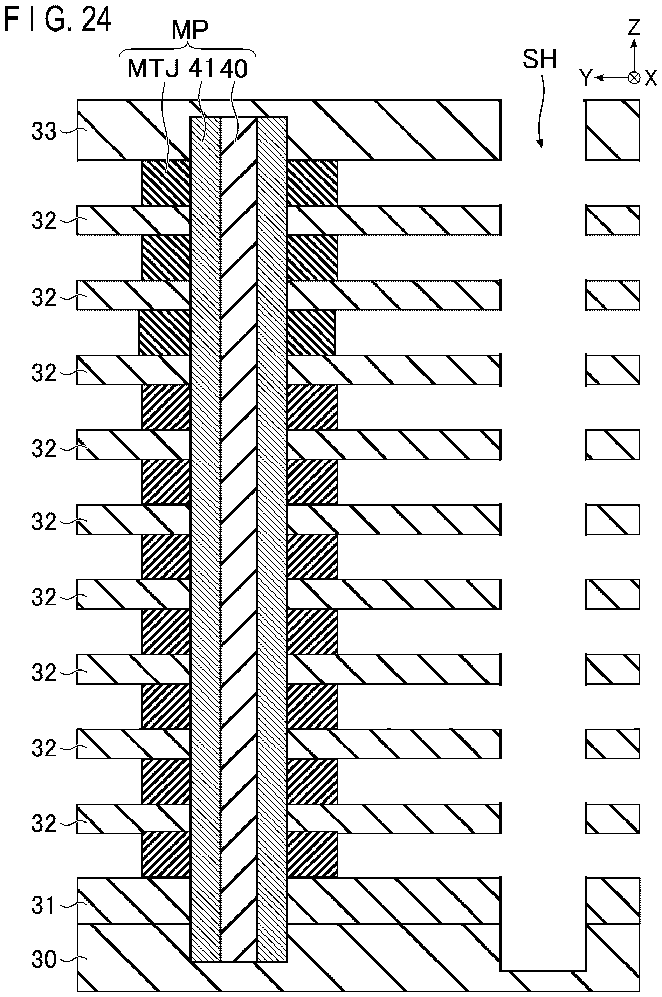

In the process of step S110, the sacrificial members 51 are removed, as shown in FIG. 24. FIG. 24 shows a cross-sectional view of the same area as depicted FIG. 16. For example, the sacrificial members 51 are selectively removed through the slit SH by wet etching. The etching solution contains, for example, phosphoric acid (H₃PO₄). Thus, a space is formed in the area where the stacked interconnect layers LL are to be formed. Since the magneto-resistive effect element MTJ includes a nonmagnetic layer 424, the ferromagnetic layer 423 is prevented from being corroded by the etching solution. The structure from which the sacrificial members 51 have been removed maintains its three-dimensional structure by a plurality of memory pillars MP.

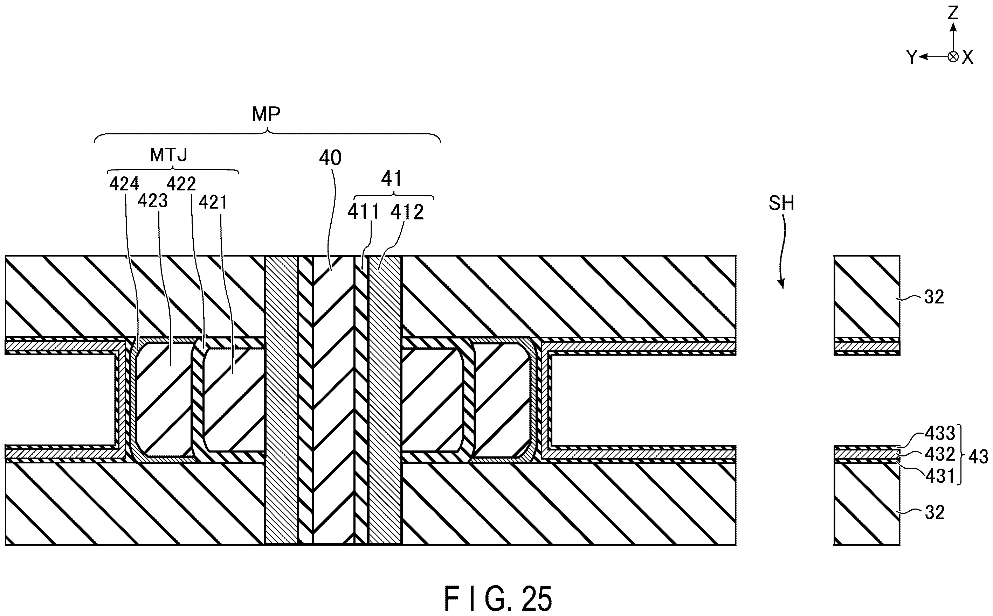

In the process of step S111, a switching layer 43 is formed, as shown in FIG. 25. FIG. 25 shows a cross-sectional view of the same area as depicted in FIG. 18. First, an underlayer 431 is formed through the slit SH on a face exposed in the space from which the sacrificial member 51 has been removed. Next, a variable resistance material layer 432 is formed on the surface of the underlayer 431 through the slit SH. Next, a cap layer 433 is formed on the surface of the variable resistance material layer 432 through the slit SH. The underlayer 431, the variable resistance material layer 432, and the cap layer 433 are formed, for example, by ALD or CVD. Thus, the switching layer 43 is formed in part of the space from which the sacrificial member 51 has been removed.

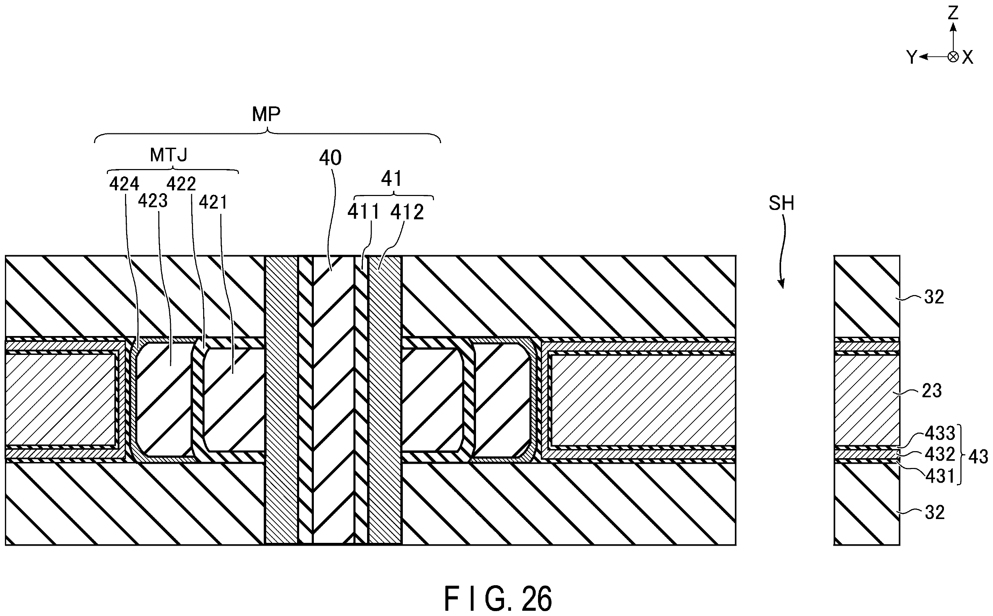

In the process of step S112, a conductive layer 23 is formed, as shown in FIG. 26. FIG. 26 shows a cross-sectional view of the same area as depicted in FIG. 18. The conductive layer 23 is formed on the surface of the cap layer 433 through the slit SH, and the space from which the sacrificial member 51 has been removed is filled with that conductive layer 23. The conductive layer 23 is formed, for example, by ALD or CVD. Then, the underlayer 431, the variable resistance material layer 432, the cap layer 433, and the conductive layer 23, which are formed inside the slit SH, are removed by an etch-back process. Thus, a plurality of stacked interconnect layers LL functioning as the read word lines RWL0 to RWL9 are formed.

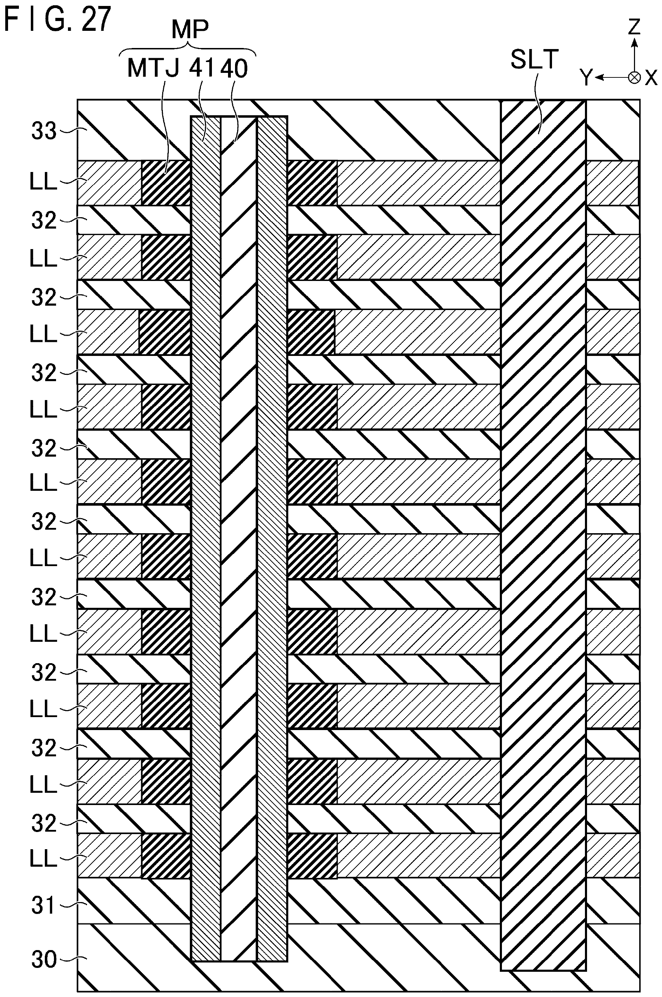

In the process of step S113, a member SLT is formed, as shown in FIG. 27. FIG. 27 shows a cross-sectional view of the same area as depicted in FIG. 16. First, the member SLT is filled in the slit SH. Next, a contact CV is provided on the memory pillar MP. Next, a conductive layer 25 functioning as the read bit line RBL is formed on the contact CV (see FIG. 5).

The manufacturing process of the magnetic memory device 1 according to the first embodiment described above forms a stacked interconnect structure in the memory cell array 10. The manufacturing process described above is merely an example, and is in no way restrictive. For example, other processes may be inserted between the manufacturing processes, or some processes may be omitted or integrated. The sequence of each manufacturing process can be rearranged provided that it does not cause any issues.

Additionally, when each layer of the magneto-resistive effect element MTJ is formed through the hole MH, each layer of the magneto-resistive effect element MTJ may be formed in a microcrystalline state, such as an amorphous state, to improve filling properties. In this case, each layer of the magneto-resistive effect element MTJ may be formed by ALD.

Additionally, for example, when each layer of the magneto-resistive effect element MTJ is formed via the hole MH, and if selective formation is desired, in order to make the layers included in the magneto-resistive effect element MTJ thicker in the spaces RP1 or RP2 than on the side face of the insulating layer 32, ALD may be used, for example.

Furthermore, for example, when each layer of the switching layer 43 is formed through the slit SH, each layer of the switching layer 43 may be formed in a microcrystalline state, such as an amorphous state, in order to improve filling properties. At this time, each layer of the switching layer 43 may be formed by ALD.

In the manufacturing method described above, an example is shown in which the sacrificial members 51 are removed after the magneto-resistive effect element MTJ is formed, but this is not restrictive. The magneto-resistive effect element MTJ or part of the magneto-resistive effect element MTJ may be formed, for example, after the sacrificial members 51 are removed. In other words, the magneto-resistive effect element MTJ or part of the magneto-resistive effect element MTJ may be formed through the slit SH. For example, in a case where the ferromagnetic layer 423 is formed through the slit SH, there is no need to protect the ferromagnetic layer 423 from the etching solution in step S110, so that the formation of the nonmagnetic layer 424 can be omitted.

The advantages of the magnetic memory device 1 according to the first embodiment will now be described.

In the magnetic memory device 1 according to the first embodiment, the magneto-resistive effect element MTJ has a circulating magnetization structure (or, a closed magnetic circuit, or a closed magnetic path). That is, the ferromagnetic layer 421 and the ferromagnetic layer 423 are formed in a cylindrical shape, and the magnetization circulates along the circumferences. Therefore, no magnetic charge is generated at the ends of the ferromagnetic layer 421 and the ferromagnetic layer 423 in a static environment. Since no magnetic charge is generated at the ends of the ferromagnetic layers 421 and 423, the magneto-resistive effect element MTJ has a structure that is stable thermally and against external magnetic fields.

Furthermore, in the magnetic memory device 1 according to the first embodiment, no magnetic charge is generated at the ends of the ferromagnetic layers 421 and 423, so no leakage magnetic field is generated externally. Thus, the magneto-resistive effect element MTJ does not cause magnetic field disturbance to adjacent bits. That is, the structure of the magneto-resistive effect element MTJ of the magnetic memory device 1 is advantageous in that disturbance from the ferromagnetic layers 421 and 423 to adjacent bits can be suppressed.

Furthermore, in the magnetic memory device 1 according to the first embodiment, the magneto-resistive effect element MTJ does not have an synthetic anti-ferromagnetic (SAF) structure. That is, the magneto-resistive effect element MTJ does not include a shift cancelling layer or a spacer layer on the outer peripheral side of the reference layer. In other words, the magneto-resistive effect element MTJ does not have a structure antiferromagnetically coupled to the ferromagnetic layer 423 between the ferromagnetic layer 423 and the stacked interconnect layers LL. This is because the ferromagnetic layer 421 and the ferromagnetic layer 423 do not generate a leakage magnetic field externally as described above, and so an SAF structure is not required to suppress any leakage magnetic field, especially from the ferromagnetic layer 423 to the ferromagnetic layer 421. As described above, the magneto-resistive effect element MTJ does not require an SAF structure, allowing the overall structure to be simplified, the design to be made easier, and manufacturing costs to be reduced.

Furthermore, in the magnetic memory device 1 according to the first embodiment, the nonmagnetic layer 422 can be provided thicker than a plate-shaped tunnel barrier layer of a magneto-resistive effect element (which may be referred to as a magneto-resistive effect element MTJr) provided in a rectangular parallelepiped shape. The insulating tunnel barrier layer should be designed to have low electrical resistance to avoid adverse effects on the read current, etc. For example, the tunnel barrier layer of the magneto-resistive effect element MTJr is designed to have low resistance by reducing its thickness.

In contrast, the nonmagnetic layer 422 can be designed to have a larger current-flowing area than the plate-shaped tunnel barrier layer because it has a cylindrical shape. In other words, the nonmagnetic layer 422 has a large current-flowing area, allowing a current to easily flow through the magneto-resistive effect element MTJ without the nonmagnetic layer 422 being thinned. The nonmagnetic layer 422 can be made thicker than the plate-shaped tunnel barrier layer, as the limitations on film thickness are suppressed. In other words, the magnetic memory device 1 according to the first embodiment enables an easier design regarding the resistance of the magneto-resistive effect element MTJ.

Furthermore, in the cylindrical magneto-resistive effect element MTJ of the magnetic memory device 1 according to the first embodiment, the ferromagnetic layer 423, which is the reference layer, is provided on the outer peripheral side of the ferromagnetic layer 421, which is the storage layer. In such a structure, the volume of the ferromagnetic layer 423 can be easily made larger than the volume of the ferromagnetic layer 421. For example, if the ferromagnetic layer 423 and the ferromagnetic layer 421 are the same in layer thickness, the volume of the ferromagnetic layer 423 will be inevitably larger than the volume of the ferromagnetic layer 421. This makes the retention energy of the reference layer larger than the retention energy of the storage layer. In other words, the magneto-resistive effect element MTJ can easily establish a difference between the retention energy of the reference layer and the retention energy of the storage layer by varying the volume of the reference layer and the volume of the storage layer.

For example, in the magneto-resistive effect element, the retention energy of the reference layer needs to be designed to be greater than the retention energy of the storage layer. In the case of the structure of the magneto-resistive effect element MTJr, it may be difficult to establish a difference between the retention energy of the reference layer and the retention energy of the storage layer based on the volume difference between the reference layer and the storage layer. In such a case, the difference in retention energy between the reference layer and the storage layer is controlled by the difference in magnetic anisotropy of the materials. In other words, different materials may be used for the reference layer and the storage layer.

In contrast, in the case of the magneto-resistive effect element MTJ, the same material can be used for the reference layer and the storage layer. The use of the same material simplifies the control of the retention energy of the magnetic material compared to the case where the magnetic anisotropy is controlled using different materials. This makes it easier to design the magneto-resistive effect element MTJ.

In addition, in the magnetic memory device 1 according to the first embodiment, the magnetic memory device 1 includes a switching layer within the stacked interconnect layers LL. Thus, the magnetic memory device 1 can prevent the read current Ir from flowing to the memory cell MC along the same read word line RWL, thereby improving the selectivity of the memory cell MC. In addition, disturbance to adjacent bits can be suppressed even with the application of voltage Vw0 or voltage Vw1.

In the magnetic memory device 1 according to the first embodiment, a write current Ic0 or Ic1 has to be supplied to write data. Therefore, erroneous writing can be prevented during a read operation (in a case where the read current Ir is supplied).

As compared with a magnetic memory device such as an STT-MRAM, the magnetic memory device 1 according to the first embodiment is advantageous in that the magnitude of the current (write current Ic0 or Ic1) flowing through the magneto-resistive effect element MTJ can be significantly reduced during a write operation.

Additionally, the magnetic memory device 1 according to the first embodiment enables film to be formed without sputtering throughout the entire manufacturing process. For example, the magnetic memory device 1 can use ALD or CVD for the film formation throughout the entire manufacturing process. Also, the magnetic memory device 1 enables etching other than ion beam etching (IBE) to be performed throughout the entire manufacturing process. For example, the magnetic memory device 1 enables use of chemical etching (wet etching or RIE) during the etching processes performed throughout the entire manufacturing process. In this manner, the magnetic memory device 1 can be manufactured using equipment that allows for a reduction in manufacturing costs throughout the entire production process.

In the magnetic memory device 1 according to the first embodiment described above, an example is shown in which the memory pillar MP includes a core member 40 in the center. However, the memory pillar MP of the magnetic memory device 1 does not need have such a core member 40. In the description below, the magnetic memory device 1, memory pillar MP, and nonmagnetic layer 412 according to a modification of the first embodiment may be referred to as a magnetic memory device 1b, a memory pillar MPb, and a nonmagnetic layer 412b, respectively, to distinguish them from the magnetic memory device 1, memory pillar MP, and nonmagnetic layer 412 of the first embodiment.

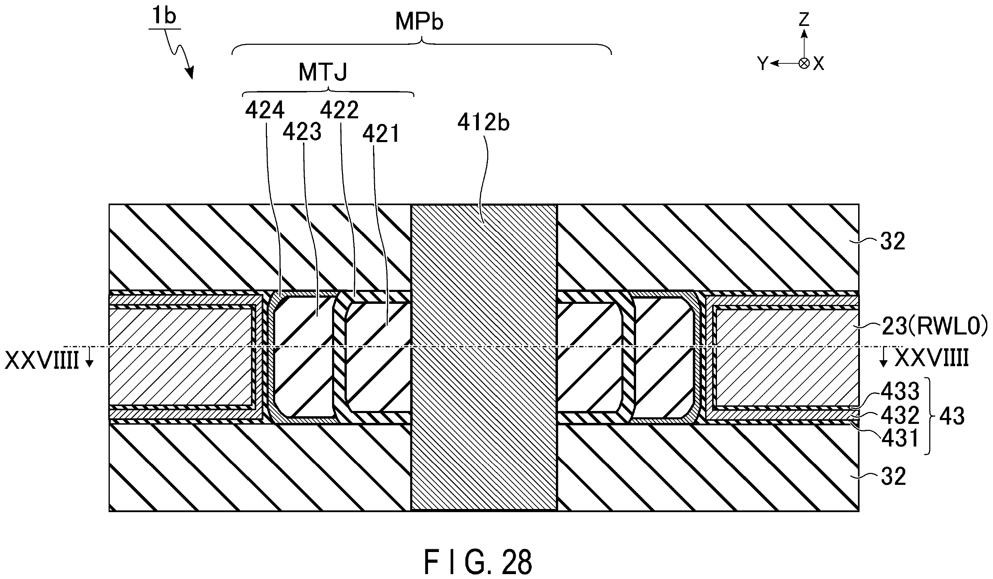

FIG. 28 shows an example of a cross-sectional structure of the memory pillar MPb provided in the magnetic memory device 1b according to the modification of the first embodiment. FIG. 28 shows part of the memory pillar MPb, and shows the structure of the stacked interconnect layer LL and the structure of the area where the memory pillar MPb intersects the stacked interconnect layer LL. FIG. 28 shows a cross-sectional view of the same area of the magnetic memory device 1 as depicted in FIG. **6****.**

As shown in FIG. 28, the memory pillar MPb does not have a core member 40 or a nonmagnetic layer 411. In the memory pillar MPb, unlike the memory pillar MP, a nonmagnetic layer 412b is filled in the area where the core member 40 and the nonmagnetic layer 411 are positioned. In other words, the nonmagnetic layer 412b extends along the Z direction and is provided in the central part of the memory pillar MP.

The structures of the magneto-resistive effect element MTJ and the stacked interconnect layer LL are the same as those of the first embodiment; therefore, a description thereof will be omitted.

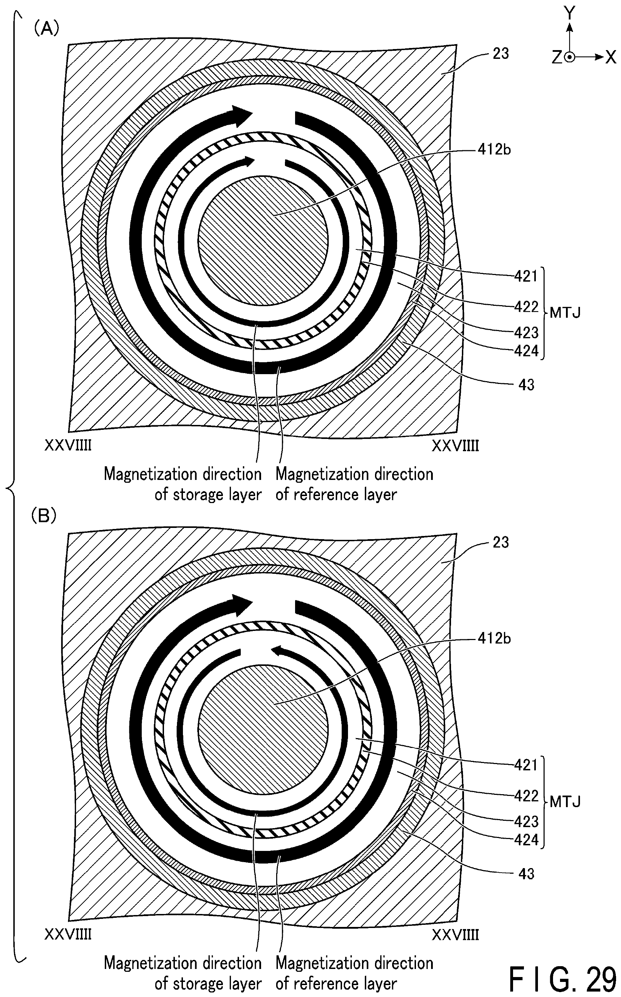

FIG. 29 is a cross-sectional view taken along line XXVIIII-XXVIIII in FIG. 28 and shows an example of the cross-sectional structure of the memory pillar MPb provided in the magnetic memory device 1b according to the modification of the first embodiment. Specifically, FIG. 29 shows the cross-sectional structure of the memory pillar MPb in a layer parallel to the surface of the semiconductor substrate 20 and including the conductive layer 23. FIG. 29 shows a cross-sectional view of the same area of the magnetic memory device 1 as depicted in FIG. **8****.** The upper part (A) of FIG. 29 shows an example in which the magneto-resistive effect element MTJ is in the low resistance state. The lower part (B) of FIG. 29 shows an example in which the magneto-resistive effect element MTJ is in the high resistance state.

In the cross section including the conductive layer 23, the nonmagnetic layer 412b is provided in the center of the memory pillar MPb. The other structures are the same as those of the first embodiment; therefore, a description thereof will be omitted.

In the magnetic memory device 1b according to the modification of the first embodiment, the radial thickness of the nonmagnetic layer 412b can be adjusted by selectively including or excluding the core member 40 and by adjusting the thickness of the nonmagnetic layer 412b in the radial direction. In other words, the current density in the nonmagnetic layer 412b (or, interconnect SOTL) can be adjusted to control the generated spin-orbit torque.

### 2. Second Embodiment

A magnetic memory device 1 according to the second embodiment will now be described. The magnetic memory device 1 according to the second embodiment is different from the magnetic memory device 1 according to the first embodiment. The magnetic memory device 1 according to the second embodiment may be referred to as a magnetic memory device 1c in the description below to distinguish it from the magnetic memory device 1 according to the first embodiment.

The memory pillar MP, magneto-resistive effect element MTJ, ferromagnetic layer 421, nonmagnetic layer 422, ferromagnetic layer 423 and nonmagnetic layer 424 that are employed in the second embodiment may be referred to as a memory pillar MPc, a magneto-resistive effect element MTJc, a ferromagnetic layer 421c, a nonmagnetic layer 422c, a ferromagnetic layer 423c, and a nonmagnetic layer 424c, respectively, to distinguish them from the memory pillar MP, magneto-resistive effect element MTJ, ferromagnetic layer 421, nonmagnetic layer 422, ferromagnetic layer 423, and nonmagnetic layer 424 that are employed in the first embodiment.

The magnetic memory device 1c differs from the magnetic memory device 1 according to the first embodiment mainly in the structure and manufacturing method of the magneto-resistive effect element MTJc. With respect to the other structures and manufacturing methods, the second embodiment is substantially the same as the first embodiment. In the following, a description will be given mainly of the points in which the magnetic memory device 1c according to the second embodiment differs from the magnetic memory device 1 according to the first embodiment.

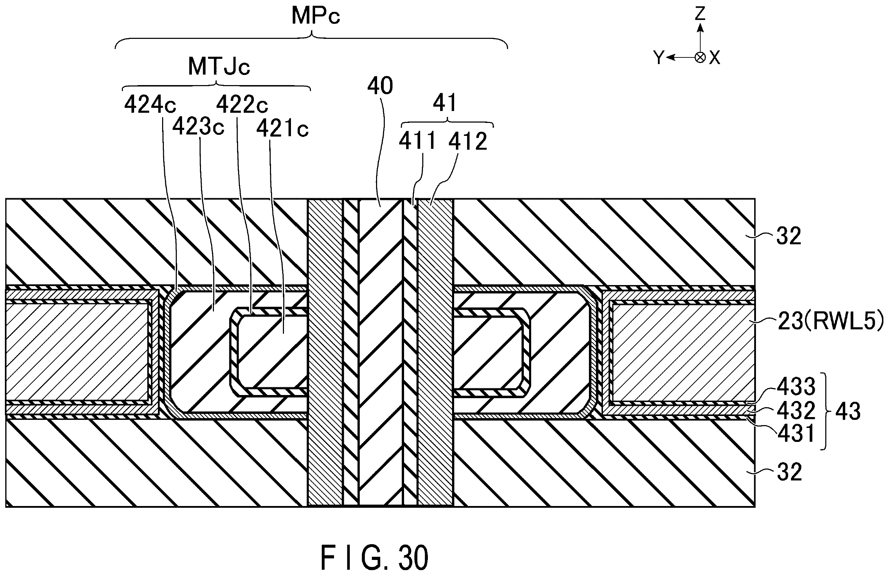

Details of the structure of the magneto-resistive effect element MTJc of the magnetic memory device 1c will be described with reference to FIG. 30. FIG. 30 shows an example of the cross-sectional structure of the memory pillar MPc provided in the magnetic memory device 1c according to the second embodiment. FIG. 30 shows part of the memory pillar MPc, and shows the structure of the stacked interconnect layer LL and structure of the area where the memory pillar MPc intersects the stacked interconnect layer LL. FIG. 30 shows a cross-sectional view of the same area of the first embodiment as depicted in FIG. 6.

As in the first embodiment, the memory pillar MPc extends along the Z direction and has a portion protruding in the XY direction. The portion protruding in the XY direction is the magneto-resistive effect element MTJc.

The structures of the core member 40 and the SOT layer 41 are the same as those of the first embodiment; therefore, a description thereof will be omitted.

The magneto-resistive effect element MTJc includes, for example, a ferromagnetic layer 421c, a nonmagnetic layer 422c, a ferromagnetic layer 423c, and a nonmagnetic layer 424c. For example, the magneto-resistive effect element MTJc has a structure in which the ferromagnetic layer 421c, the nonmagnetic layer 422c, the ferromagnetic layer 423c, and the nonmagnetic layer 424c are in contact with the SOT layer 41. That is, the magneto-resistive effect element MTJc differs from the magneto-resistive effect element MTJ mainly in that not only the ferromagnetic layer 421c and the nonmagnetic layer 422c but also the ferromagnetic layer 423c and the nonmagnetic layer 424c are in contact with the SOT layer 41.

Specifically, the ferromagnetic layer 421c is provided on the side face of the nonmagnetic layer 412 in a layer including the stacked interconnect layer LL. The nonmagnetic layer 422c covers the surface of the ferromagnetic layer 421c except for the portion where the ferromagnetic layer 421c and the nonmagnetic layer 412c are in contact with each other. The ferromagnetic layer 423c covers the surface of the ferromagnetic layer 422c except for the portion where the nonmagnetic layer 422c and the ferromagnetic layer 421c are in contact with each other. The nonmagnetic layer 424c covers the surface of the ferromagnetic layer 423c except for the portion where the ferromagnetic layer 423c and the nonmagnetic layer 422c are in contact with each other.

In other words, for example, the ferromagnetic layer 421c is in contact with the nonmagnetic layer 412. The nonmagnetic layer 422c is provided between the insulating layer 32 and the ferromagnetic layer 421c, and has a first portion that is in contact with the nonmagnetic layer 412. The ferromagnetic layer 423c is provided between the insulating layer 32 and the first portion, and has a second portion that is in contact with the nonmagnetic layer 412.

The materials and functions of the ferromagnetic layer 421c, the nonmagnetic layer 422c, the ferromagnetic layer 423c, and the nonmagnetic layer 424c are the same as those of the ferromagnetic layer 421, the nonmagnetic layer 422, the ferromagnetic layer 423, and the nonmagnetic layer 424, respectively; therefore, a description thereof will be omitted.

The structure of the stacked interconnect layer LL is the same as that of the first embodiment; therefore, a description thereof will be omitted.

Next, a method for manufacturing the magnetic memory device 1c according to the second embodiment will be described. The method for manufacturing the magnetic memory device 1c according to the second embodiment differs from the method for manufacturing the magnetic memory device 1 according to the first embodiment mainly in the formation of the magneto-resistive effect element MTJc.

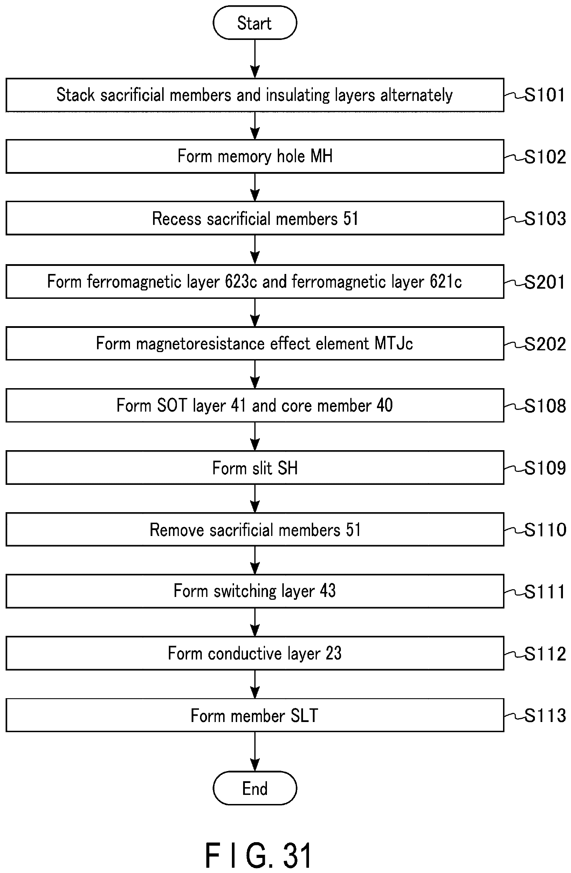

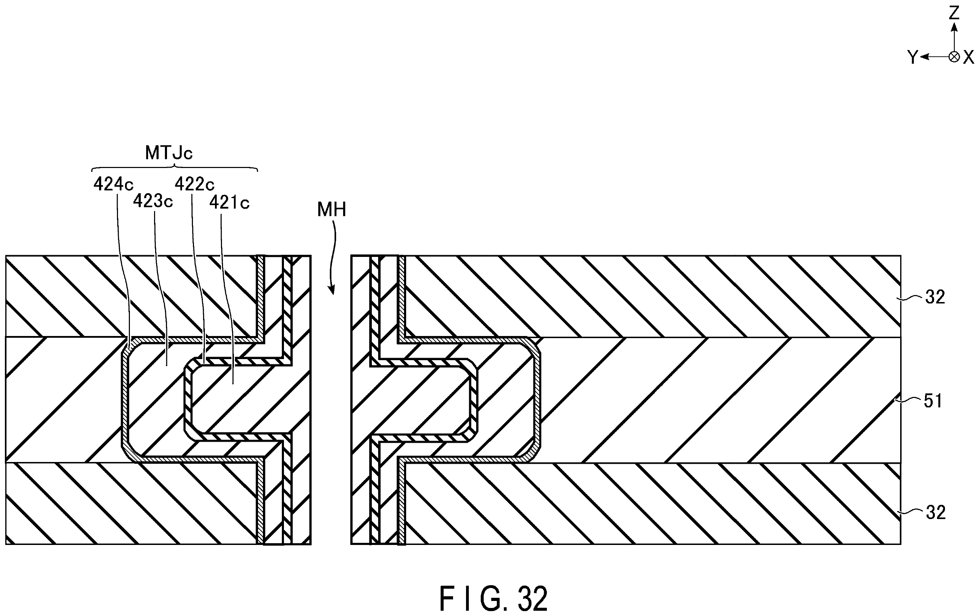

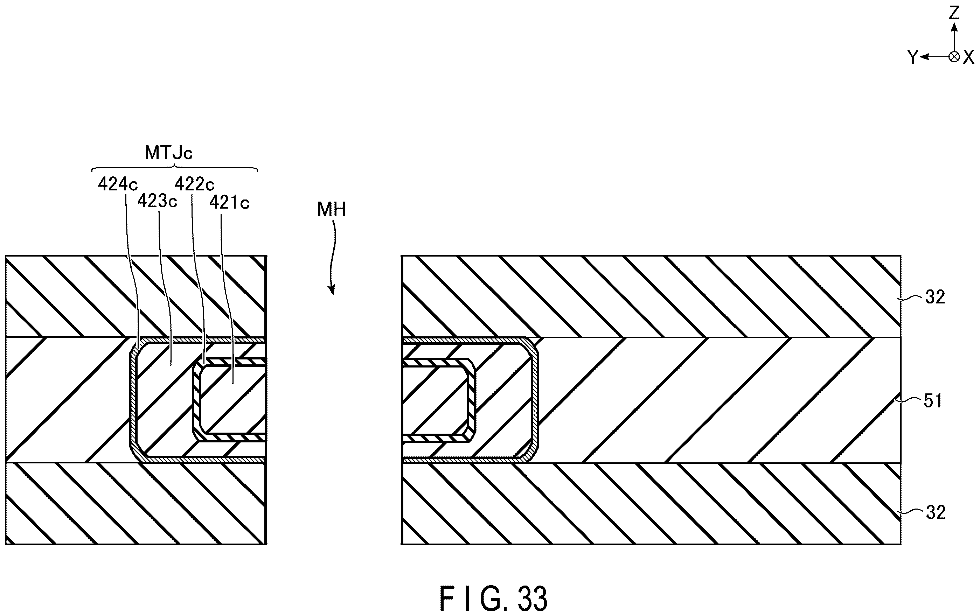

FIG. 31 is a flowchart showing an example of the method for manufacturing the magnetic memory device 1c according to the second embodiment. FIG. 32 and FIG. 33 show an example of a cross-sectional structure during manufacturing of the magnetic memory device 1c according to the second embodiment. FIG. 32 and FIG. 33 each show a cross-sectional view of the same area as depicted in FIG. 20. In the following, an example of the manufacturing steps for forming the stacked interconnect structure of the memory cell array 10 in the magnetic memory device 1c according to the second embodiment will be described with reference to FIG. 31 as appropriate. As shown in FIG. 31, the method for manufacturing the magnetic memory device 1c according to the second embodiment sequentially performs steps S101 to S103, S201, S202 and S108 to S113, for example.

First, as in the first embodiment, steps S101 to S103 are sequentially performed.

In the process of step S201, a nonmagnetic layer 424c, a ferromagnetic layer 623c, a nonmagnetic layer 422c, and a ferromagnetic layer 621c are formed, as shown in FIG. 32. Specifically, the nonmagnetic layer 424c is first formed on the surface and bottom face of the hole MH and on the face exposed in the space RP1. Next, the ferromagnetic layer 623c is formed on the surface of the nonmagnetic layer 424c. Next, the nonmagnetic layer 422c is formed on the surface of the ferromagnetic layer 623c. Next, the ferromagnetic layer 621c is formed on the surface of the nonmagnetic layer 422c. The nonmagnetic layer 424c, the ferromagnetic layer 623c, the nonmagnetic layer 422c, and the ferromagnetic layer 621c fill the space RP1, for example.

The nonmagnetic layer 424c, the ferromagnetic layer 623c, the nonmagnetic layer 422c, and the ferromagnetic layer 621c are successively formed in a single vacuum process using ALD or CVD. A ferromagnetic layer 423c is formed from a portion of the ferromagnetic layer 623c by performing the process described below. A ferromagnetic layer 421c is formed from a portion of the ferromagnetic layer 621c by performing the process described below.

In the process of step S202, a magneto-resistive effect element MTJc is formed, as shown in FIG. 33. Specifically, wet etching is performed through the hole MH. The wet etching solution etches the nonmagnetic layer 424c, the ferromagnetic layer 623c, the nonmagnetic layer 422c, and the ferromagnetic layer 621c that are formed in the hole MH. In other words, the nonmagnetic layer 424c, the ferromagnetic layer 623c, the nonmagnetic layer 422c and the ferromagnetic layer 621c that are formed on the side face of the insulating layer 32 are removed. The ferromagnetic layer 623c and the ferromagnetic layer 621c subjected to the etching process will be referred to as a ferromagnetic layer 423c and a ferromagnetic layer 421c, respectively. That is, the ferromagnetic layer 623c and the ferromagnetic layer 621c are etched to form the ferromagnetic layer 423c and the ferromagnetic layer 421c, respectively.

Then, as in the first embodiment, the processes of steps S108 to S113 are sequentially performed. Thus, in the second embodiment, a stacked interconnect structure is formed in the memory cell array. The manufacturing process described above is merely an example, and other processes may be inserted between the manufacturing processes.

The advantages of the magnetic memory device 1c according to the second embodiment will now be described.

In the magnetic memory device 1c according to the second embodiment, the ferromagnetic layer 421c, the nonmagnetic layer 422c, the ferromagnetic layer 423c and the nonmagnetic layer 424c of the magneto-resistive effect element MTJc are sequentially formed in a single vacuum process. This prevents films of the magneto-resistive effect element MTJc from being exposed to air during film formation. Thus, the magneto-resistive effect element MTJc can prevent the inclusion of impurities such as oxide films. By preventing the inclusion of impurities, the magneto-resistive effect element MTJc can avoid deterioration of its characteristics.

### 3. Other Modifications

All or part of the above embodiments may be described as in the following supplementary notes, but are not limited to the following.

### (Supplementary Note 1)

A magnetic memory device comprising:
a substrate;
a first interconnect and a first insulator extending in a first direction along the substrate;
a second insulator extending in the second direction and penetrating the first interconnect and the first insulator;
a second interconnect (41) provided around the second insulator, extending in the second direction, and penetrating the first interconnect and the first insulator; and
a first magneto-resistive effect element (MTJ) provided in a ring-shape around the second interconnect between the first interconnect and the second interconnect,
wherein the first magneto-resistive effect element includes:
   a first ferromagnetic material (421) between the second interconnect and the first interconnect;
   a first nonmagnetic material (422) between the first ferromagnetic material and the first interconnect; and
   a second ferromagnetic material (423) between the first nonmagnetic material and the first interconnect.

### (Supplementary Note 2)

The magnetic memory device as described in supplementary note 1, wherein
the first interconnect and the first insulator are arranged in a second direction intersecting the first direction, and
the magnetic memory device further comprises a first switching element provided between the first interconnect and the first magneto-resistive effect element and coupled in series to the first magneto-resistive effect element;
   and/or
the first switching element is a selector having a nonlinear current-voltage characteristic, a selector having a snapback characteristic, or a diode.

### (Supplementary Note 3)

The magnetic memory device as described in supplementary note 1, further comprising:
a plurality of third interconnects and a plurality of third insulators extending in the first direction, arranged alternately in the second direction, and penetrated by the second interconnect and the second insulator; and
a plurality of second magneto-resistive effect elements between the plurality of third interconnects and the second interconnect and provided in a ring-shape around the second interconnect,
wherein each of the plurality of second magneto-resistive effect elements includes:
   a third ferromagnetic material between the second interconnect and one of the third interconnects;
   a second nonmagnetic material between the third ferromagnetic material and the one of the third interconnects; and
   a fourth ferromagnetic material between the second nonmagnetic material and the one of the third interconnects.

### (Supplementary Note 4)

The magnetic memory device as described in supplementary note 1, wherein
in a write operation for writing data to the first magneto-resistive effect element,
a first voltage is applied to the first interconnect,
a second voltage lower than the first voltage is applied to a first end of the second interconnect, and a third voltage higher than the second voltage is applied to a second end of the second interconnect, and
the third voltage has a magnitude that causes a first current to flow from the second end to the first end;
   and/or
the second voltage is a ground voltage.

### (Supplementary Note 5)

The magnetic memory device as described in supplementary note 1, wherein
the first ferromagnetic material is in contact with the second interconnect,
the first nonmagnetic material further includes a portion that is provided between the first insulator and the first ferromagnetic material and in contact with the second interconnect, and
the second ferromagnetic material is not in contact with the second interconnect.

### (Supplementary Note 6)

The magnetic memory device as described in supplementary note 1, wherein
the first ferromagnetic material is in contact with the second interconnect,
the first nonmagnetic material further includes a first portion that is provided between the first insulator and the first ferromagnetic material and in contact with the second interconnect, and
the second ferromagnetic material further includes a second portion that is provided between the first insulator and the first portion and in contact with the second interconnect.

### (Supplementary Note 7)

The magnetic memory device as described in supplementary note 2, wherein
the first magneto-resistive effect element further includes:
a third nonmagnetic material between the second ferromagnetic material and the first interconnect, and
the first switching element includes:
   a first conductor on the first interconnect;
   a variable resistance material on the first conductor; and
   a second conductor on the variable resistance material;
      and/or

the third nonmagnetic material contains at least one element selected from tantalum (Ta), tungsten (W), and titanium (Ti);
   and/or
the variable resistance material contains at least one element selected from sulfur (S), selenium (Se), tellurium (Te), boron (B), aluminum (Al), gallium (Ga), indium (In), carbon (C), silicon (Si), germanium (Ge), tin (Sn), arsenic (As), phosphorus (P), bismuth (Bi), and antimony (Sb).

### (Supplementary Note 8)

The magnetic memory device as described in supplementary note 1, wherein
the first nonmagnetic material contains at least one element selected from boron (B), magnesium (Mg), and aluminum (Al), and
the first ferromagnetic material and the second ferromagnetic material contain at least one element selected from cobalt (Co), iron (Fe), and nickel (Ni);
   and/or
the first nonmagnetic layer contains hexagonal boron nitride (h-BN) or hexagonal aluminum nitride (h-AlN).

### (Supplementary Note 9)

A manufacturing method of a magnetic memory device, comprising:
forming a stacked structure in which a sacrificial member and a first insulator are alternately stacked along a second direction;
forming a memory hole extending in the second direction and penetrating the stacked structure;
removing a portion of the sacrificial member through the memory hole;
forming a second ferromagnetic material in a first space from which the sacrificial member has been removed;
removing a portion of the second ferromagnetic material through the memory hole;
forming a first nonmagnetic material and a first ferromagnetic material in this order in the first space and part of the memory hole;
removing portions of the first nonmagnetic material and the first ferromagnetic material through the memory hole;
forming a second interconnect extending in the second direction in the memory hole;
forming a slit that divides the stacked structure;
selectively removing the sacrificial member through the slit;
forming a variable resistance material in a portion of a space from which the sacrificial member has been removed;
forming a first interconnect in the space from which the sacrificial member has been removed; and
forming a fourth insulator in the slit,
wherein the first ferromagnetic material and the second ferromagnetic material are formed in a ring-shape between the first interconnect and the second interconnect, and
the first ferromagnetic material and the second ferromagnetic material have an axis of easy magnetization along a circumferential direction.

### (Supplementary Note 10)

The manufacturing method of the magnetic memory device, as described in supplementary note 9, further comprising:
forming a second insulator in the memory hole after the second interconnect is formed in the memory hole.

### (Supplementary Note 11)

The manufacturing method of the magnetic memory device, as described in supplementary note 9, wherein the second ferromagnetic material, the first nonmagnetic material, the first ferromagnetic material, the second interconnect, the first interconnect, and the variable resistance material are formed by atomic layer deposition (ALD) or chemical vapor deposition (CVD).

### (Supplementary Note 12)

A manufacturing method of a magnetic memory device, comprising:
forming a stacked structure in which a sacrificial member and a first insulator are alternately stacked along a second direction;
forming a memory hole extending in the second direction and penetrating the stacked structure;
removing a portion of the sacrificial member through the memory hole;
forming a second ferromagnetic material, a first nonmagnetic material, and a first ferromagnetic material in this order in a first space from which the sacrificial member has been removed and a portion of the memory hole;
removing portions of the second ferromagnetic material, the first nonmagnetic material, and the first ferromagnetic material through the memory hole;
forming a second interconnect extending in the second direction in the memory hole;
forming a slit that divides the stacked structure;
selectively removing the sacrificial member through the slit;
forming a variable resistance material in a portion of a space from which the sacrificial member has been removed;
forming a first interconnect in the space from which the sacrificial member has been removed; and
forming a fourth insulator in the slit,
wherein the first ferromagnetic material and the second ferromagnetic material are formed in a ring-shape between the first interconnect and the second interconnect, and
the first ferromagnetic material and the second ferromagnetic material have an axis of easy magnetization along a circumferential direction.

### (Supplementary Note 13)

The manufacturing method of the magnetic memory device, as described in supplementary note 12, further comprising:
forming a second insulator in the memory hole after the second interconnect is formed in the memory hole.

In the first and second embodiments, the structures of the magnetic memory devices 1 to 1c may be other structures. The structures of the magnetic memory devices 1, 1b, and 1c may be other structures.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A magnetic memory device comprising:
a substrate (20);
a first interconnect (RWL) and a first insulator (32) extending in a first direction along the substrate;
a second insulator (40) extending in the second direction and penetrating the first interconnect and the first insulator;
a second interconnect (41) provided around the second insulator, extending in the second direction, and penetrating the first interconnect and the first insulator; and
a first magneto-resistive effect element (MTJ) provided in a ring-shape around the second interconnect between the first interconnect and the second interconnect,
wherein the first magneto-resistive effect element includes:
a first ferromagnetic material (421) between the second interconnect and the first interconnect;
a first nonmagnetic material (422) between the first ferromagnetic material and the first interconnect; and
a second ferromagnetic material (423) between the first nonmagnetic material and the first interconnect.

2. The magnetic memory device according to claim 1, wherein
the first interconnect and the first insulator are arranged in a second direction intersecting the first direction, and
the magnetic memory device further comprises a first switching element provided between the first interconnect and the first magneto-resistive effect element and coupled in series to the first magneto-resistive effect element;
and/or
the first switching element is a selector having a nonlinear current-voltage characteristic, a selector having a snapback characteristic, or a diode.

3. The magnetic memory device according to claim 1, further comprising:
a plurality of third interconnects and a plurality of third insulators extending in the first direction, arranged alternately in the second direction, and penetrated by the second interconnect and the second insulator; and
a plurality of second magneto-resistive effect elements between the plurality of third interconnects and the second interconnect and provided in a ring-shape around the second interconnect,
wherein each of the plurality of second magneto-resistive effect elements includes:
a third ferromagnetic material between the second interconnect and one of the third interconnects;
a second nonmagnetic material between the third ferromagnetic material and the one of the third interconnects; and
a fourth ferromagnetic material between the second nonmagnetic material and the one of the third interconnects.

4. The magnetic memory device according to claim 1, wherein
in a write operation for writing data to the first magneto-resistive effect element,
a first voltage is applied to the first interconnect,
a second voltage lower than the first voltage is applied to a first end of the second interconnect, and a third voltage higher than the second voltage is applied to a second end of the second interconnect, and
the third voltage has a magnitude that causes a first current to flow from the second end to the first end;
and/or
the second voltage is a ground voltage.

5. The magnetic memory device according to claim 1, wherein
the first ferromagnetic material is in contact with the second interconnect,
the first nonmagnetic material further includes a portion that is provided between the first insulator and the first ferromagnetic material and in contact with the second interconnect, and
the second ferromagnetic material is not in contact with the second interconnect.

6. The magnetic memory device according to claim 1, wherein
the first ferromagnetic material is in contact with the second interconnect,
the first nonmagnetic material further includes a first portion that is provided between the first insulator and the first ferromagnetic material and in contact with the second interconnect, and
the second ferromagnetic material further includes a second portion that is provided between the first insulator and the first portion and in contact with the second interconnect.

7. The magnetic memory device according to claim 2, wherein
the first magneto-resistive effect element further includes:
a third nonmagnetic material between the second ferromagnetic material and the first interconnect, and
the first switching element includes:
a first conductor on the first interconnect;
a variable resistance material on the first conductor; and
a second conductor on the variable resistance material;
and/or
the third nonmagnetic material contains at least one element selected from tantalum (Ta), tungsten (W), and titanium (Ti);
and/or
the variable resistance material contains at least one element selected from sulfur (S), selenium (Se), tellurium (Te), boron (B), aluminum (Al), gallium (Ga), indium (In), carbon (C), silicon (Si), germanium (Ge), tin (Sn), arsenic (As), phosphorus (P), bismuth (Bi), and antimony (Sb).

8. The magnetic memory device according to claim 1, wherein
the first nonmagnetic material contains at least one element selected from boron (B), magnesium (Mg), and aluminum (Al), and
the first ferromagnetic material and the second ferromagnetic material contain at least one element selected from cobalt (Co), iron (Fe), and nickel (Ni);
and/or
the first nonmagnetic layer contains hexagonal boron nitride (h-BN) or hexagonal aluminum nitride (h-AlN).

9. A manufacturing method of a magnetic memory device, comprising:
forming a stacked structure in which a sacrificial member (51) and a first insulator (32) are alternately stacked along a second direction;
forming a memory hole extending in the second direction and penetrating the stacked structure;
removing a portion of the sacrificial member through the memory hole;
forming a second ferromagnetic material (423), a first nonmagnetic material (422), and a first ferromagnetic material (421) in this order in a first space from which the sacrificial member has been removed and a portion of the memory hole;
removing portions of the second ferromagnetic material, the first nonmagnetic material, and the first ferromagnetic material through the memory hole;
forming a second interconnect (SOT) extending in the second direction in the memory hole;
forming a slit that divides the stacked structure;
selectively removing the sacrificial member through the slit;
forming a variable resistance material (432) in a portion of a space from which the sacrificial member has been removed;
forming a first interconnect (RWL) in the space from which the sacrificial member has been removed; and
forming a fourth insulator (SLT) in the slit,
wherein the first ferromagnetic material and the second ferromagnetic material are formed in a ring-shape between the first interconnect and the second interconnect, and
the first ferromagnetic material and the second ferromagnetic material have an axis of easy magnetization along a circumferential direction.

10. The manufacturing method according to claim 9, further comprising:
forming a second insulator in the memory hole after the second interconnect is formed in the memory hole.
